# EUROPÄISCHE PATENTSCHRIFT

(11) **EP 1 308 275 B1**
(45) Veröffentlichungstag und Bekanntmachung des Hinweises auf die Patenterteilung: **11.08.2004**
(21) Anmeldenummer: 02024902.5
(22) Anmeldetag: 05.11.2002
(51) Int. Cl.: B41F 15/36

(54) **Spannrahmen mit Druckschablone**
Tensioning frame for a screen
Cadre pour tendre un pochoir

(30) Priorität: 05.11.2001 DE 10154265
(43) Veröffentlichungstag der Anmeldung: 07.05.2003
(73) Patentinhaber: LaserJob GmbH, 82284 Grafrath (DE)
(72) Erfinder: Kleemann, Georg, 82288 Kottgeisering (DE); Englmaier, Robert, 86929 Penzing (DE)
(74) Vertreter: Bösl, Raphael, Dr. rer. nat., Dipl.-Chem.

(56) Entgegenhaltungen:
- DE-C- 522 794
- GB-A- 2 317 366
- US-A- 2 566 919
- US-A- 3 273 497
- US-A- 6 038 969

## Beschreibung

Die vorliegende Erfindung betrifft einen Spannrahmen sowie eine zugehörige Druckschablone. Druckschablonen im Sinne der Erfindung sind insbesondere Schablonen für den Auftrag von Lotpaste auf elektronische Leiterplatten mittels eines Siebdruckverfahrens und allgemein Schablonen für Siebdruckverfahren für das Aufbringen pastöser Druckmassen auf Träger. Die Erfindung betrifft auch ein Verfahren zum Spannen einer erfindungsgemäßen Druckschablone mit dem erfindungsgemäßen Spannrahmen sowie die Verwendung des erfindungsgemäßen Spannrahmens für eine erfindungsgemäße Druckschablone.

Aus der Patentschrift DE 693 17 559 T2 ist eine Vorrichtung für Schablonierungsvorgänge bekannt, mit einer Stahlschablone mit mindestens zwei gegenüberliegenden Seitenbereichen, die eine Vielzahl von eng beabstandeten, länglichen Schlitzen aufweisen und flexibler als der Hauptteil der Schablone ausgebildet sind, und einem Halterungsrahmen mit einer Vielzahl von eng beabstandeten, kammartigen Zähnen, die mit den Schlitzen der Schablone korrespondieren. Die Schablone kann in dem Halterungsrahmen eingespannt werden, indem die Schlitze mit den Zähnen in Eingriff gebracht werden und die Zähne gespannt werden, wobei die flexiblen Seitenbereiche der Schablone gebogen oder gekrümmt werden, so dass die Zähne des Halterungsrahmens die unterste Planarfläche der Schablone in deren betriebsmäßiger Lage nicht nach unten überragen.

Die vorstehend beschriebene Vorrichtung aus dem Stand der Technik weist zahlreiche Nachteile auf. Die Herstellung des Spannrahmens mit der Vielzahl von eng beabstandeten, kammartigen Zähnen, die so gelagert sind, dass sie mittels einer Drehbewegung aus der untersten Planarfläche des Rahmens seitlich ausgelenkt werden können, ist aufwendig. Auch die Herstellung jeder einzelnen Schablone mit flexiblen Randbereichen und mit einer Vielzahl von länglichen, eng beabstandeten Schlitzen ist aufwendig. Bei Stahlschablonen mit größerer Stärke muss die Stärke der Randbereiche zusätzlich verringert werden, um eine ausreichende Flexibilität für die erforderliche Biegung oder Krümmung zu ermöglichen. Dabei entsteht das zusätzliche Problem, dass die erforderliche Zugfestigkeit der Randbereiche für das Spannen einer Folie mit großer Stärke verloren geht, weil die schmalen Randbereiche zwischen den eng beabstandeten Schlitzen der Zugspannung der eingreifenden Zähne des Spannrahmens nicht Stand halten. Aus dem gleichen Grund können grundsätzlich keine Stahlschablonen geringer Stärke und keine Kunststoffschablonen gespannt werden.

Aus der Patentschrift DE 196 15 058 C2 sind eine Spannvorrichtung und Schablonen, sowie entsprechende Schablonenrohlinge für Schablonen oder Siebdruck bekannt. Die Spannvorrichtung weist zwei Befestigungsvorrichtungen für zwei gegenüberliegende Seiten einer Schablone auf, die zum Halten von zwei mit der Schablone verbundenen Leisten ausgestaltet sind, sowie zwei zwischen den Befestigungsvorrichtungen angeordnete, höher liegende, parallel zu diesen verlaufende, als Kanten ausgebildete Tragelemente für die Schablone, wobei die Schablone ausschließlich auf den Kanten aufliegt und die dadurch begrenzte Druckfläche der Schablone der tiefste Teil der Vorrichtung ist. Für das Wechseln und Spannen der Schablone ist eine der beiden Befestigungsvorrichtungen mittels zweier über Schubstangen verbundener, an beiden Enden der Befestigungsvorrichtung angeordneter, pneumatischer Betätigungsvorrichtungen verschiebbar ausgebildet.

Auch die vorstehende Vorrichtung aus dem Stand der Technik weist zahlreiche Nachteile auf. Die Spannvorrichtung ermöglicht keinen ausreichenden Ausgleich von Toleranzen in der parallelen Anordnung der mit der Schablone verbundenen Leisten oder von Toleranzen des gleichförmigen Vorschubs der beiden parallel angeordneten Betätigungsvorrichtungen. Für den Toleranzausgleich ist lediglich eine pendelnde Aufhängung der Befestigungsvorrichtungen, nämlich pendelnde Aufhängungen der verschiebbaren Befestigungsvorrichtung an den beiden Schubstangen vorgesehen. Wegen der beiden zwischen den Befestigungsvorrichtungen angeordneten, höher liegenden Tragelemente für die Schablone entsteht eine zu der Zugspannung der Betätigungsvorrichtungen proportionale seitliche Kraftkomponente, die aus der Ebene der Zugspannung der Betätigungsvorrichtungen hinaus weist. Die seitliche Kraftkomponente erfordert eine aufwendige Lagerung der Schubstangenführungen und der verschiebbaren Befestigungsvorrichtung, insbesondere auch der pendelnden Aufhängungen der verschiebbaren Befestigungsvorrichtung an den beiden Schubstangen, die durch die seitliche Kraftkomponente in ihrer Funktion behindert und starkem Verschleiß ausgesetzt sind, sowie eine massive Dimensionierung der Schubstangen und eine gegen seitliches Herausrutschen gesicherte, aufwendige, weit auskragende Ausgestaltung der Leisten auf der Schablone und zusätzliche Umfassungen und Nuten der Befestigungsvorrichtungen, die einen Wechsel der Schablone erschweren.

Die in DE 196 15 058 beschriebene Spannvorrichtung ermöglicht schon wegen der im Vergleich zu den Befestigungsvorrichtungen höher liegenden Tragelemente lediglich ein Spannen der Schablone in einer Richtung. Auch machen die Nuten der Befestigungsmittel, die nur ein seitliches Einschieben der Folie erlauben, das Spannen der Folie in mehr als einer Richtung unmöglich. Bei den Ausführungsformen mit weit auskragenden Nasen oder Umfassungen der Befestigungsmittel muss das bewegliche Befestigungsmittel um eine lange Strecke verschoben werden, um die Schablone zu entnehmen. Benachbarte bewegliche Befestigungsmittel für ein Spannen in zwei senkrecht zueinander ausgerichteten Richtungen sind deshalb aus räumlichen Gründen auch bei den vorstehenden Ausführungsformen nicht möglich.

Bei Schablonen mit geringer Steifheit, insbesondere dünnen Folien und Kunststofffolien, kann bei dem Spannen in nur einer Richtung die Bildung von Wellen in der Schablone nicht verhindert werden. Die als Kanten ausgebildeten Tragelemente, auf denen die gespannte Schablone alleine aufliegt, führen bei Schablonen größerer Stärke zu der Bildung von Knicken, an denen die Schablone einem erhöhten Verschleiß ausgesetzt ist. Bei dünnen Folien und insbesondere bei Kunststofffolien besteht die Gefahr einer Überdehnung, plastischen Streckung und eines Abreißens der Schablone im Bereich der Kanten.

Aus der Druckschrift US 2,566,919 ist ein Spannrahmen mit einer Seidenschablone bekannt, die an ihren Kanten Schlaufen aufweist, in die Rundstäbe einschiebbar sind. Die Schlaufen können in Umfassungen an den unteren Enden von Spannmitteln des Spannrahmens eingeführt und mittels der Rundstäbe verbunden werden. Die mittels eines Scharniers an ihrem oberen Ende mit den oberen Enden der Außenseiten des Spannrahmens drehbar verbundenen Spannmittel weisen Spannschrauben auf, die durch den mittleren Teil des Spannmittels geführt und mit ihrem unteren Ende an einem unteren Abschnitt der Außenseite des Spannrahmens gelagert sind. Die Spannschrauben ermöglichen ein Auslenken der unteren Enden der Spannmittel von den Rahmenaußenseiten weg und ein Spannen der verbundenen Schablone.

Der aus US 2,566,919 bekannte Spannrahmen weist den Nachteil auf, dass es sich um einen aktiv spannenden Rahmen handelt, bei dem die Spannung der Schablone mittels Spannschrauben eingestellt werden muss. Die zugehörige Schablone weist aus Schlaufen und Rundstäben zusammengesetzte Befestigungsmittel auf, die zeitaufwendig in der Handhabung sind.

Der vorliegenden Erfindung liegt die Aufgabe zugrunde, einen neuen Spannrahmen mit einfacherer Handhabung und eine neue zugehörige, einfacher zu wechselnde Druckschablone bereitzustellen. Die Aufgabe wird mit den Merkmalen der nebengeordneten Ansprüche 1, 2, 12 und 16 bis 23 gelöst. Vorteilhafte Ausführungen der Erfindung ergeben sich aus den Unteransprüchen.

Im folgenden wird die Erfindung anhand von vorteilhaften Ausführungsbeispielen in Verbindung mit einer schematischen Zeichnung mehr im einzelnen und ohne jede Beschränkung beschrieben. Weitere im Rahmen der Erfindung liegende vorteilhafte Ausführungsbeispiele lassen sich für den Fachmann aufgrund seines Fachwissens ohne weiteres auffinden. Die Erfindung wird in den Ausführungsbeispielen und Figuren ohne Beschränkung hinsichtlich weiterer erfindungsgemäßer Ausführungen beschrieben, die der Fachmann aufgrund der vorliegenden Beschreibung und seines Fachwissens ohne weiteres auffinden kann.

In der schematischen Zeichnung zur Veranschaulichung der erfindungsgemäßen Ausführungsbeispiele zeigt:
- Figur 1: einen Spannrahmen mit einer Druckschablone in seitlicher Ansicht;
- Figur 2: eine erste Druckschablone mit Profilleisten in seitlicher Ansicht;
- Figur 3: eine weitere Druckschablone mit Profilleisten in der Aufsicht;
- Figur 4: einen weiteren Spannrahmen mit einer Druckschablone in gebrochener Darstellung, in perspektivischer Ansicht;
- Figur 5: ein Rahmenprofil mit einem Randbereich einer Druckschablone im Schnitt;
- Figur 6: ein weiteres Rahmenprofil mit einem Randbereich einer Druckschablone im Schnitt;
- Figur 7: ein Rahmenprofil mit elastischen Spannmitteln in der Aufsicht;
- Figur 8: ein Rahmenprofil mit einem elastischen Spannmittel im Schnitt;
- Figur 9: ein Rahmenprofil mit einem weiteren elastischen Spannmittel im Schnitt;
- Figur 10: ein Rahmenprofil mit einem noch weiteren elastischen Spannmittel im Schnitt;
- Figur 11: eine rahmenförmige Vorspannvorrichtung in der Aufsicht;
- Figur 12: einen Schnitt durch die Vorspannvorrichtung in Figur 11 entlang der Fläche A-A';
- Figur 13: einen Ausschnitt aus Figur 12 in gebrochener Darstellung;
- Figur 14: einen Ausschnitt in gebrochener Darstellung einer weiteren Vorspannvorrichtung;
- Figur 15: einen weiteren Spannrahmen in der Aufsicht; und
- Figur 16: den Spannrahmen aus Figur 15 in seitlicher Ansicht.

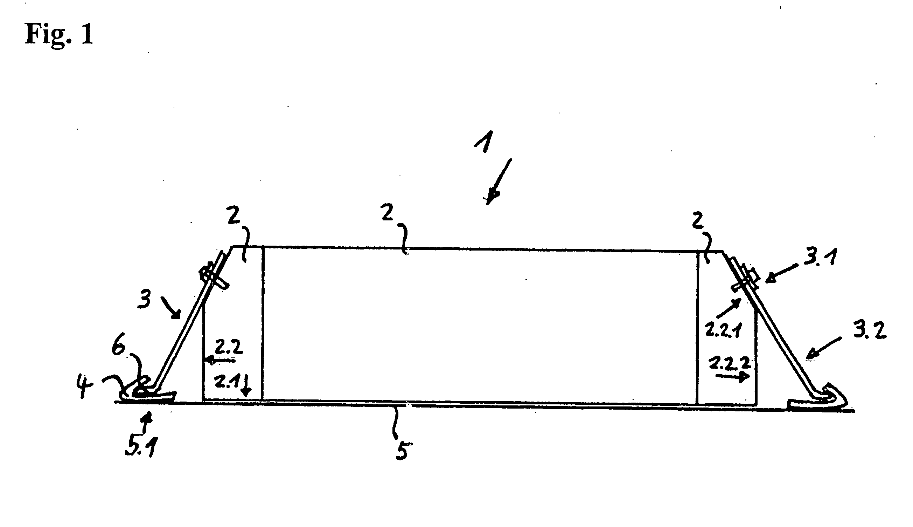

Die Figur 1 zeigt in schematischer Darstellung ein erstes Ausführungsbeispiel eines erfindungsgemäßen Spannrahmens 1 mit einer erfindungsgemäßen Druckschablone 5. Der Spannrahmen liegt mit den Unterseiten 2.1 seiner Rahmenprofile 2 auf der Druckschablone auf und ist mittels elastischer Spannmittel 3, die an zwei gegenüberliegenden Rahmenprofilen angeordnet sind, lösbar mit der Druckschablone verbunden. Die Spannmittel greifen mittels Eingriffsmitteln 6 unter Spannung in parallele Profilleisten 4 ein, die in gegenüberliegenden Randbereichen 5.1 der Schablone auf der Schablonenoberfläche in fester Verbindung angeordnet sind. Dabei ist die Druckschablone mit ihrer gesamten Fläche einschließlich ihrer Randbereiche 5.1 weitgehend plan in einer Ebene gespannt.

Der rechteckige Spannrahmen besteht aus vier fest miteinander verbundenen Rahmenprofilen 2, vorteilhafter Weise mit im wesentlichen rechteckigem Querschnitt. Die Rahmenprofile bestehen vorteilhafter Weise aus Metall, insbesondere aus Edelstahl, oder aus einem Kunststoff mit hoher Steifheit und besitzen eine vorbestimmte Stärke, um im wesentlichen ohne Verformung einer vorbestimmten Zugspannung der Druckschablone Stand zu halten. Die Rahmenprofile können bei vorteilhaften Ausführungsformen massiv, hohl, im wesentlichen U- oder T-förmig oder mit anderem Querschnitt von ausreichender Steifheit ausgebildet sein, den der Fachmann aufgrund seines Fachwissens auffindet. Benachbarte Rahmenprofile sind fest miteinander verbunden, insbesondere durch Verschweißen, Verschrauben, Vernieten oder eine beliebige andere feste, lösbare oder nicht lösbare Verbindung, die der Fachmann aufgrund seines Fachwissens auffindet.

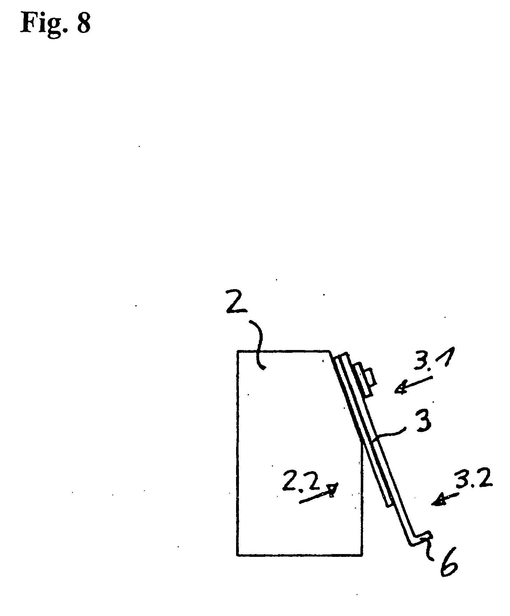

Bei dem in der Figur 1 gezeigten ersten Ausführungsbeispiel tragen zwei gegenüberliegende Rahmenprofile an ihren Außenseiten 2.2 elastische Spannmittel 3, die, wie nachstehend beispielsweise in dem Ausführungsbeispiel in Figur 8 gezeigt, vorteilhafter Weise als Blattfedern ausgebildet sein können. Die beiden gegenüberliegenden, elastische Spannmittel tragenden Rahmenprofile liegen mit ihren Unterseiten 2.1 weitgehend plan auf der Druckschablone auf. Die beiden Rahmenprofile ohne elastische Spannmittel liegen je nach einer vorbestimmten Breite der Druckschablone ebenfalls ganz oder teilweise auf der Oberfläche der Druckschablone auf oder liegen nicht auf der Druckschablone auf. Die elastischen Spannmittel sind mit oberen Abschnitten 3.1 an oberen Abschnitten 2.2.1 der Außenseiten der Rahmenprofile in fester Verbindung angeordnet. Die feste Verbindung kann mittels Verschweißen, Klemmverbindung, Kleben, Verschrauben, Vernieten oder beliebigen weiteren, für den Fachmann aufgrund seines Fachwissens auffindbaren festen, lösbaren oder unlösbaren Verbindungen hergestellt sein.

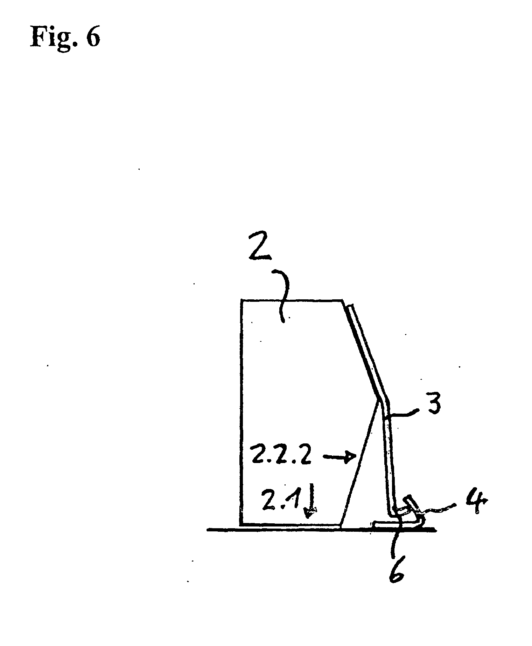

Die oberen Abschnitte 2.2.1 der Außenseiten der Rahmenprofile, an denen die oberen Abschnitte 3.1 der elastischen Spannmittel in fester Verbindung angeordnet sind, sind als in Richtung zu der Rahmenmitte hin geneigte Flächen ausgebildet. Die unteren Abschnitte 2.2.2 der Außenseiten der Rahmenprofile sind im wesentlichen senkrecht zu der Druckschablone ausgebildet oder schließen vorteilhafter Weise, wie nachstehend beispielsweise in dem Ausführungsbeispiel in Figur 6 gezeigt, einen stumpfen Winkel mit der Unterseite 2.1 des Rahmenprofils ein.

Die unteren Abschnitte 3.2 der elastischen Spannmittel tragen Eingriffsmittel 6, die an einen lösbaren Eingriff in die mit der Druckschablone verbundenen Profilleisten angepasst sind. Die Eingriffsmittel 6 können beispielsweise abgewinkelte untere Randbereiche von als Blattfedern ausgebildeten elastischen Spannmitteln sein. Die Eingriffsmittel sind im wesentlichen hakenförmig-, schenkel- oder nasenförmig ausgebildet. Die Eingriffsmittel können in beliebigen Ausgestaltungen, die der Fachmann aufgrund seines Fachwissens auffindet, vorteilhafter Weise einstückig mit den Spannmitteln, insbesondere aus dem gleichen Material, ausgebildet sein, oder können aus ausgewählten Materialien gefertigt und in fester Verbindung an den Spannmitteln angeordnet sein.

Wie beispielsweise in der Figur 1 gezeigt, greifen die Eingriffsmittel 6 unter Spannung in die gegenüberliegenden Profilleisten 4 der Druckschablone ein und halten die Druckschablone im wesentlichen in einer Ebene plan gespannt. Dabei liegt die Druckschablone an den unteren Seiten 2.1 von Rahmenprofilen, insbesondere der die Spannmittel tragenden Rahmenprofile, an. Die unteren Abschnitte 3.2 der elastischen Spannmittel sind in einem geringen Abstand von den unteren Abschnitten 2.2.2 der Außenseiten der Rahmenprofile angeordnet. Der Abstand zwischen den unteren Abschnitten der elastischen Spannmittel und den Rahmenprofilen ist jedoch ausreichend bemessen, um die Eingriffsmittel mittels weiterer Vorspannung der Spannmittel aus den Profilleisten der Druckschablone auszulenken, so dass die Verbindung zwischen dem Spannrahmen und der Druckschablone gelöst und der Spannrahmen von der Druckschablone abgenommen werden kann.

Bei einem weiteren erfindungsgemäßen Ausführungsbeispiel ist der Abstand zwischen den unteren Abschnitten der elastischen Spannmittel und den Rahmenprofilen zumindest so bemessen, dass bei maximaler Vorspannung der Spannmittel an dem einen Rahmenprofil die Spannmittel an diesem Rahmenprofil anliegen, so dass an dem gegenüberliegenden Rahmenprofil der Abstand zu den verbundenen Spannmitteln ausreichend vergrößert ist, um mittels Vorspannung dieser Spannmittel die verbundenen Eingriffsmittel aus der Profilleiste der Druckschablone auszulenken und die Verbindung zwischen dem Spannrahmen und der Druckschablone zunächst einseitig zu lösen. Bei dem anschließenden Abnehmen des Spannrahmens von der Druckschablone können die Spannmittel auf der gegenüberliegenden Rahmenseite entspannt und die Verbindung zu der Druckschablone vollständig gelöst werden.

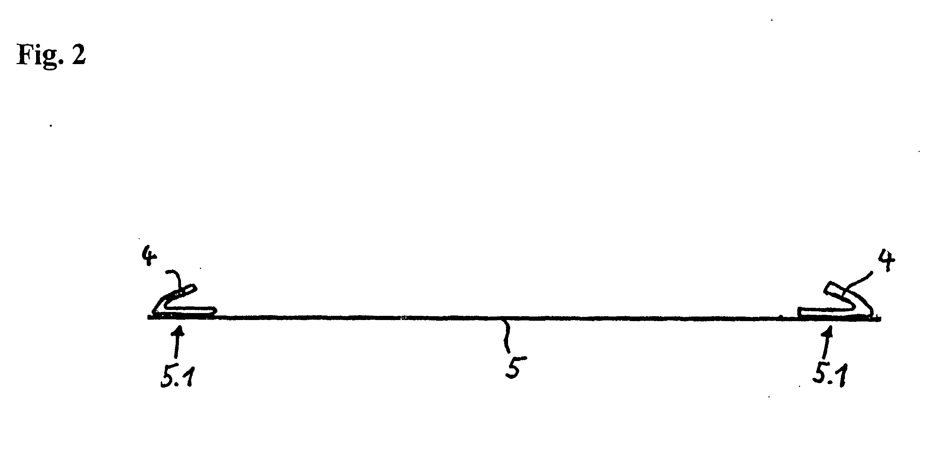

Die Figur 2 zeigt in schematischer Darstellung ein erstes Ausführungsbeispiel einer erfindungsgemäßen Druckschablone 5 mit zwei gegenüberliegenden Randbereichen 5.1 mit fest verbundenen Profilleisten 4. Die in Figur 2 gezeigte Druckschablone ist insbesondere für eine lösbare Verbindung mit dem vorstehend beschriebenen, in Figur 1 gezeigten Spannrahmen des ersten Ausführungsbeispiels mit elastischen Spannmitteln an zwei gegenüberliegenden Rahmenprofilen geeignet.

Die erfindungsgemäßen Druckschablonen 5 bestehen aus einer Schablonenfolie, beispielsweise aus einer Metallfolie, insbesondere aus einer Edelstahlfolie, oder einer Kunststofffolie, insbesondere einer Polyimidfolie, mit fest verbundenen, parallelen Profilleisten 4 an wenigstens zwei Rändern 5.1 der Druckschablone. Die Metall- oder Kunststofffolien sind für den Auftrag pastöser Materialien mittels Siebdruckverfahren auf Träger, insbesondere für den Auftrag von Lotpaste auf Leiterplatten, geeignet. Die Druckschablonen weisen vollständige Durchbrechungen für den Auftrag der pastösen Materialien auf. Die Durchbrechungen sind in den Metallfolien insbesondere mittels Ätzverfahren oder mittels Laser hergestellt. In Kunststofffolien sind die Durchbrechungen insbesondere mittels Laser hergestellt. Die Druckschablonen weisen bei vorteilhaften Ausführungsformen Bereiche mit unterschiedlichen, vorbestimmten Stärken, insbesondere für den Auftrag der pastösen Materialien in unterschiedlicher Stärke auf.

Druckschablonen im Sinne der Erfindungen umfassen auch Rohlinge für die Herstellung von Druckschablonen mit einer Schablonenfolie und mit fest verbundenen, parallelen Profilleisten 4 an wenigstens zwei Rändern 5.1 der Druckschablone, die mittels der erfindungsgemäßen Spannrahmen spannbar sind. Die Rohlinge können in den erfindungsgemäßen Spannrahmen gespannt werden, um die Ausbildung von Durchbrechungen, insbesondere mittels Laser, Ätzverfahren, in der gespannten Schablonenfolie zu ermöglichen. Die Rohlinge können ebenso in den erfindungsgemäßen Spannrahmen gespannt werden, um die Ausbildung von Bereichen unterschiedlicher Stärke mit bekannten Verfahren oder weitere Herstellungsschritte von Druckschablonen an der gespannten Schablonenfolie zu ermöglichen.

Die Profilleisten 4 sind an gegenüberliegenden Rändern 5.1 der Druckschablone 5 in paralleler Ausrichtung angeordnet. Die Profilleisten sind vorteilhafter Weise aus Metall, insbesondere aus Edelstahl und mittels Stanzverfahren oder Prägeverfahren hergestellt. Die Profilleisten können auch aus Kunststoff hergestellt sein. In jedem Fall verfügen sie über eine ausreichende Zugfestigkeit für das Spannen der Druckschablone. Die Profilleisten weisen vorteilhafter Weise einen im wesentlichen spitzwinkeligen oder U-förmigen Querschnitt auf. Die Profilleisten sind vorteilhafter Weise mittels eines Schenkels fest mit der Druckschablone verbunden. Die Profilleisten einer Druckschablone können jeweils mit der Unterseite oder der Oberseite der Schablone verbunden sein. Jedenfalls überragen sie die Schablone gleichseitig, vorzugsweise auf deren Oberseite.

Die Profilleisten sind mit der Schablone fest verbunden, beispielsweise durch Kleben, Schweißen, insbesondere Laserschweißen, Vernieten oder durch andere feste Verbindungen, die der Fachmann aufgrund seines Fachwissens auffindet. Der Schenkel einer Profilleiste, der mit der Schablone fest verbunden ist, kann an die Art der festen Verbindung angepasst sein, insbesondere kann die Breite des Schenkels an das Aufkleben der Profilleiste, insbesondere auf eine Kunststofffolie, angepasst sein.

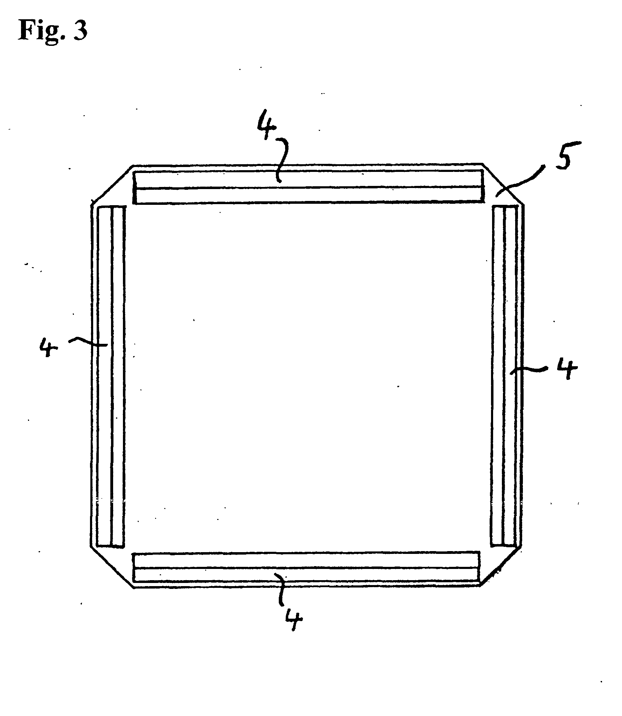

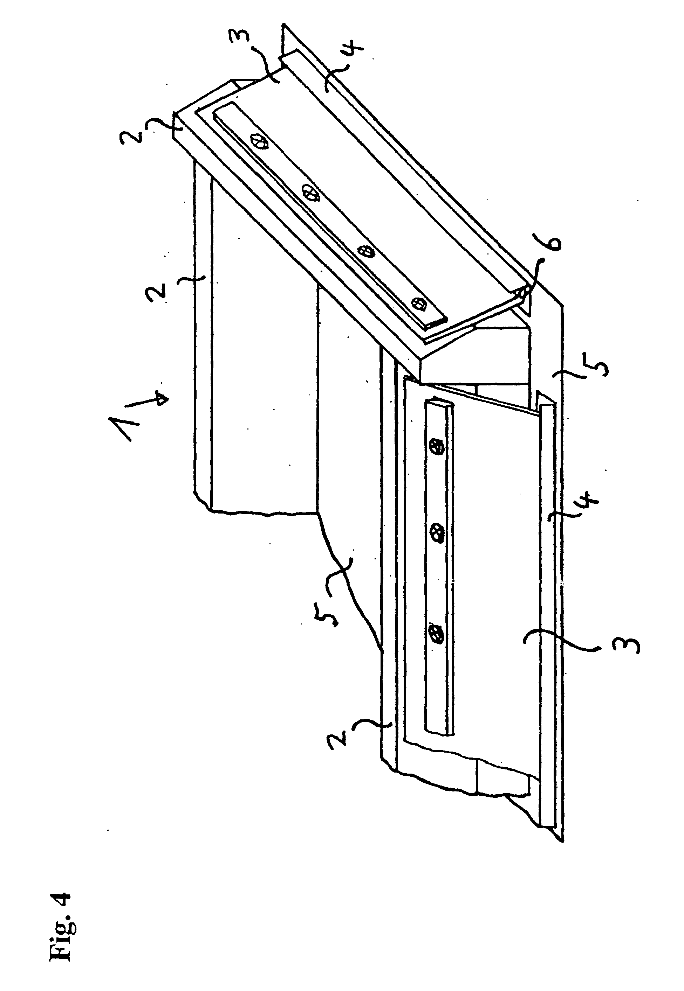

Die Längen der Profilleisten 4 einer Druckschablone können vorteilhafter Weise an die Breite der elastischen Spannmittel 3 eines Spannrahmens angepasst sein. Bei einem vorteilhaften Ausführungsbeispiel ist, wie in Figur 3 gezeigt, jeweils an einem Rand der Druckschablone 5 eine durchgehende, einstückig ausgebildete Profilleiste 4 angeordnet. Bei weiteren, nicht gezeigten vorteilhaften Ausführungsformen ist jeweils an einem Rand der Druckschablone 5 an Stelle einer durchgehenden Profilleiste eine vorbestimmte Anzahl von mehreren Profilleisten mit vorbestimmten Abständen zueinander angeordnet. Die Profilleisten können sich über die gesamte Breite der Druckschablone erstrecken oder, wie in Figur 4 gezeigt, nur über einen vorbestimmten Teil der Breite der Druckschablone.

Die Figur 3 zeigt in schematischer Darstellung ein weiteres vorteilhaftes Ausführungsbeispiel einer erfindungsgemäßen rechteckigen Druckschablone 5 mit an allen vier Rändern in fester Verbindung angeordneten Profilleisten 4. Gegenüberliegende Profilleisten sind parallel zueinander ausgerichtet. Vorteilhafter Weise erstrecken sich die Profilleisten nicht über die gesamte Breite der Druckschablone, sondern die Ecken der Druckschablone sind von Profilleisten frei gehalten. Bei Druckschablonen mit an mehr als zwei gegenüberliegenden Rändern angeordneten Profilleisten können die Ecken der Druckschablone, wie in Figur 3 gezeigt, vorteilhafter Weise auch abgeschnitten sein.

Eine nicht in einer Figur gezeigte vorteilhafte Ausführung der Erfindung sieht Hilfsmittel für das parallele Ausrichten von Profilleisten und deren Anordnung auf der Druckschablonenfolie vor, die die richtige Ausrichtung und Anordnung während der Durchführung der festen Verbindung von Profilleisten und Druckschablone erleichtern. Beispielsweise kann ein Hilfsmittel als Schablone ausgebildet sein, die erste Ausrichtungsmittel für Profilleisten, insbesondere in Form von parallelen Vertiefungen, enthält und zweite Ausrichtungsmittel für die Druckschablone.

Die Figur 4 zeigt in schematischer Darstellung ein weiteres vorteilhaftes Ausführungsbeispiel eines rechteckigen Spannrahmens 1 mit einer darunter angeordneten Druckschablone 5. In Figur 4 ist die Anordnung des Spannrahmens mit der Druckschablone in perspektivischer Ansicht gezeigt, wobei lediglich ein Teil der Anordnung in gebrochener Darstellung gezeigt ist. Gezeigt sind ein in voller Breite dargestelltes Rahmenprofil 2 mit gebrochenen Abschnitten der beiden angrenzenden Rahmenprofile 2 und einem gebrochenen Abschnitt der Druckschablone 5. Die Darstellung ist in der linken Hälfte von Figur 4 gedanklich mit identischen Abschnitten der gebrochen dargestellten Rahmenprofile, einem dazwischen angeordneten identischen vierten Rahmenprofil und einem identischen Abschnitt der gebrochen dargestellten Druckschablone zu ergänzen.

An allen vier Rahmenprofilen 2 ist auf den Außenseiten 2.2 jeweils ein einzelnes elastisches Spannmittel 3 angeordnet, das sich über einen vorbestimmten Abschnitt der Breite des Rahmenprofils erstreckt und an die Länge der auf der Druckschablone angeordneten Profilleisten 5 angepasst ist. Der Einfachheit der Darstellung halber, jedoch ohne Begrenzung des Ausführungsbeispiels, weisen zwei erste gegenüberliegende Rahmenprofile elastische Spannmittel auf, deren Breite an Profilleisten angepasst ist, die sich über die volle Breite der Druckschablone erstrecken, und zweite gegenüberliegende Rahmenprofile, die zwischen den ersten Rahmenprofilen angeordnet sind, weisen elastische Spannelemente auf, die sich nur über einen Teil der Breite der Druckschablone erstrecken. Das in Figur 4 gezeigte Ausführungsbeispiel erstreckt sich jedoch insbesondere auch auf Spannrahmen mit elastischen Spannmitteln, die an eine Druckschablone des in Figur 3 gezeigten Ausführungsbeispiels angepasst sind.

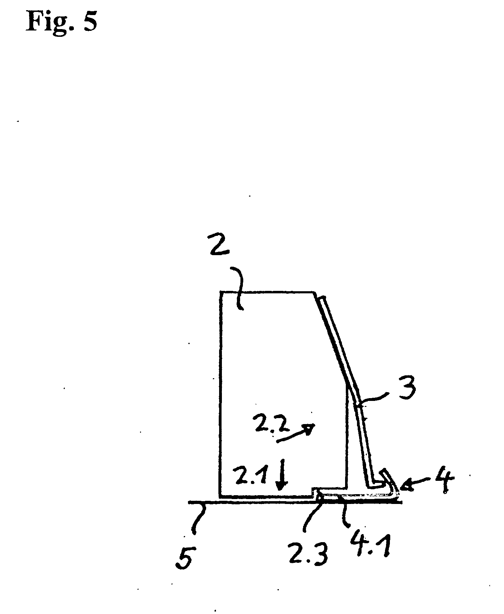

Die Figur 5 zeigt ein vorteilhaftes Ausführungsbeispiel eines Rahmenprofils 2 eines erfindungsgemäßen Spannrahmens mit einem darunter angeordneten Abschnitt einer gespannten Druckschablone 5. An der Außenseite 2.2 des Rahmenprofils ist ein elastisches Spannmittel 3 angeordnet, das unter Spannung in eine Profilleiste 4 eingreift, die auf der Oberfläche der Druckschablone 5 angeordnet ist. Das Rahmenprofil weist eine Ausnehmung 2.3 seiner Längskante zwischen seiner Außenseite 2.2 und seiner Unterseite 2.1 auf. Die Ausnehmung 2.3 ist vorteilhafter Weise an einen Schenkel 4.1 des Rahmenprofils 4 angepasst, der mit der Oberseite der Schablone 5 verbunden ist, und ermöglicht eine zumindest teilweise Aufnahme des Schenkels 4.1 unter den äußeren Rand des Rahmenprofils 2. Dadurch wird ein Spannen des Randbereichs 5.1 der Druckschablone weitgehend plan und in einer Ebene mit dem mittleren Abschnitt der Druckschablone ermöglicht. Vorteilhafter Weise ermöglicht eine Ausnehmung 2.3 das Spannen in einer Ebene von Druckschablonen mit Rahmenprofilen mit einem breit ausgebildeten Schenkel 4.1, der mit der Oberfläche der Druckschablone verbunden ist, insbesondere das Spannen von Kunststofffolien mit aufgeklebten Profilleisten

Die Figur 6 zeigt ein weiteres vorteilhaftes Ausführungsbeispiel eines Rahmenprofils 2 eines erfindungsgemäßen Spannrahmens mit einem darunter angeordneten Abschnitt einer gespannten Druckschablone 5. An der Außenseite 2.2 des Rahmenprofils ist ein elastisches Spannmittel 3 angeordnet, das unter Spannung in eine Profilleiste 4 eingreift, die auf der Oberfläche der Druckschablone 5 angeordnet ist. Der untere Abschnitt 2.2.2 der Außenseite des Rahmenprofils schließt mit der Unterseite 2.1 des Rahmenprofils einen stumpfen Winkel ein. Der untere Abschnitt 2.2.2, der bei einem Vorspannen des elastischen Spannmittels als Anschlag dient, ermöglicht bei diesem Ausführungsbeispiel ein stärkeres Vorspannen und eine vorteilhafte weitere Auslenkung des Eingriffsmittels 6 aus der Profilleiste 4, wodurch ein Wechseln der Schablone erleichtert wird. Bei dem in Figur 6 gezeigten Ausführungsbeispiel erübrigt sich vorteilhafter Weise teilweise oder vollständig das Ausbilden der in Figur 5 gezeigten Ausnehmung 2.3 des Rahmenprofils.

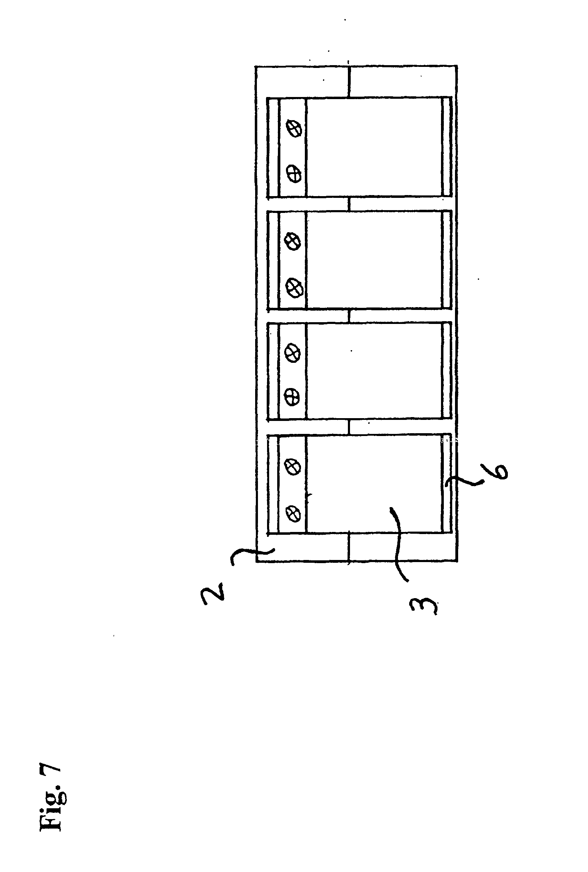

Die Figur 7 zeigt in schematischer Darstellung ein weiteres Ausführungsbeispiel eines Rahmenprofils 2 eines erfindungsgemäßen Spannrahmens. An dem Rahmenprofil 2 ist eine vorbestimmte Mehrzahl von elastischen Spannmitteln 3 angeordnet. Die elastischen Spannmittel können erfindungsgemäß an wenigstens einem Rahmenprofil angeordnet sein und unmittelbar benachbart oder mit vorbestimmten Abständen angeordnet sein. Die in Figur 7 gezeigte Anordnung einer Mehrzahl von elastischen Spannmitteln bezieht sich auf alle erfindungsgemäßen Spannrahmen und alle erfindungsgemäßen elastischen Spannmittel und beinhaltet auch beliebige kombinierte Anordnungen von verschieden ausgebildeten elastischen Spannmitteln an wenigstens einem Rahmenprofil.

Die Figur 8 zeigt ein Rahmenprofil 2 eines erfindungsgemäßen Spannrahmens mit einem vorteilhaften Ausführungsbeispiel eines elastischen Spannmittels 3. Das elastische Spannmittel 3 ist an der Außenseite 2.2 des Rahmenprofils angeordnet und als Blattfeder ausgebildet. Vorteilhafter Weise besteht das Spannmittel aus wenigstens zwei übereinander angeordneten und mit dem Rahmenprofil fest verbundenen Blattfedern. Das Eingriffsmittel 6 ist wenigstens an der zu oberst liegenden Blattfeder ausgebildet. Die darunter angeordneten Blattfedern können die gleiche oder eine vorbestimmte andere, vorzugsweise eine kürzere Länge als die zuoberst angeordnete Blattfeder aufweisen.

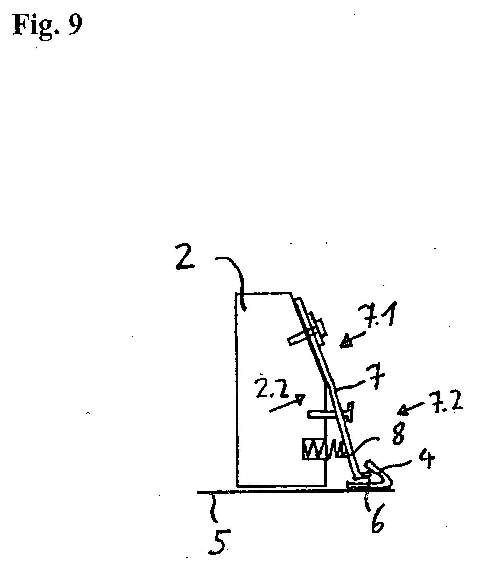

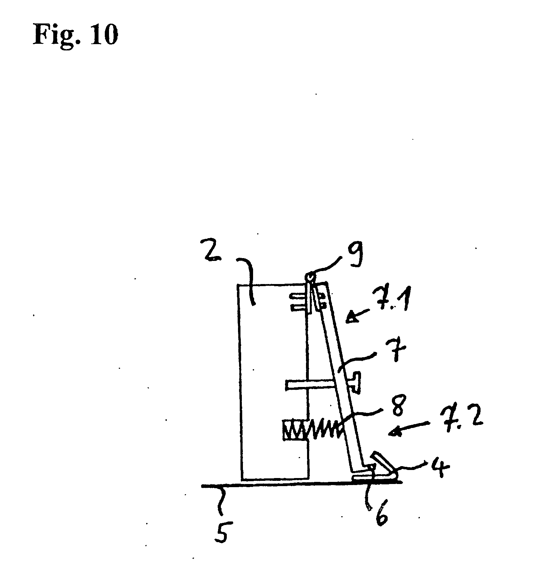

Die Figuren 9 und 10 zeigen weitere vorteilhafte Ausführungsbeispiele des elastischen Spannmittels 3. Das elastische Spannmittel 3 besteht bei den in den Figuren 9 und 10 gezeigten Ausführungsbeispielen aus einem Spannprofil 7, das mit einem oberen Abschnitt 7.1 mit dem oberen Abschnitt 2.2.1 der Außenseite 2.2 des Rahmenprofils 2 fest verbunden ist. Ein Federmittel 8, das mit dem unteren Abschnitt 2.2.2 der Außenseite des Rahmenprofils verbunden ist, spannt einen unteren beweglichen Abschnitt 7.2 des Spannprofils vor. An dem unteren Ende des Spannprofils ist ein Eingriffsmittel 6 für einen lösbaren Eingriff in eine Profilleiste einer Druckschablone ausgebildet. Das Federmittel 8 kann vorteilhafter Weise mittels einer Sackbohrung in dem Rahmenprofil 2 gehalten sein. Die durch das Federmittel 8 bewirkte Vorspannung des beweglichen Abschnitts 7.2 des Spannprofils kann durch ein ausgewähltes Begrenzungsmittel, insbesondere durch eine Schraube begrenzt sein, die durch eine Bohrung in dem Spannprofil geführt und mit vorbestimmtem Abstand in dem Rahmenprofil 2 verankert ist.

Bei dem in Figur 9 gezeigten Ausführungsbeispiel besteht das Spannprofil 7 aus einer Blattfeder mit als Eingriffsmittel 6 ausgebildetem unteren Rand, die mit ihrem oberen Abschnitt 7.1 in fester Verbindung an dem als geneigte Fläche ausgebildeten oberen Abschnitt 2.2.1 des Rahmenprofils verbunden ist.

Bei dem in Figur 10 gezeigten Ausführungsbeispiel besteht das Spannprofil 7 aus einem starren Profil, das insbesondere als einteiliges Frästeil mit einem Eingriffsmittel 6 ausgebildet sein kann, und an seinem oberen Ende mittels eines Gelenks 9, insbesondere mittels eines Scharniers, mit dem oberen Abschnitt 2.2.1 des Rahmenprofils, insbesondere mit dessen oberem Rand, drehbar verbunden ist. Der obere Abschnitt 2.2.1 der Außenseite des Rahmenprofils ist dabei im wesentlichen als senkrechte Fläche ausgebildet.

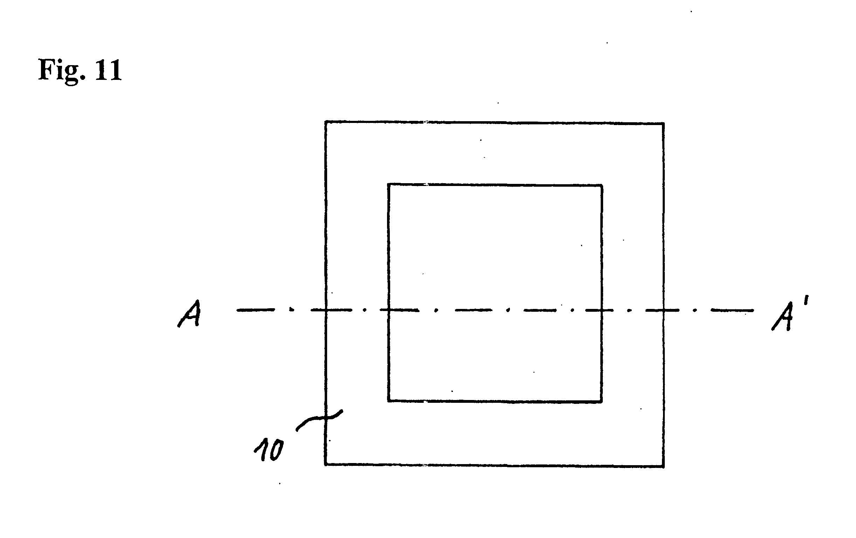

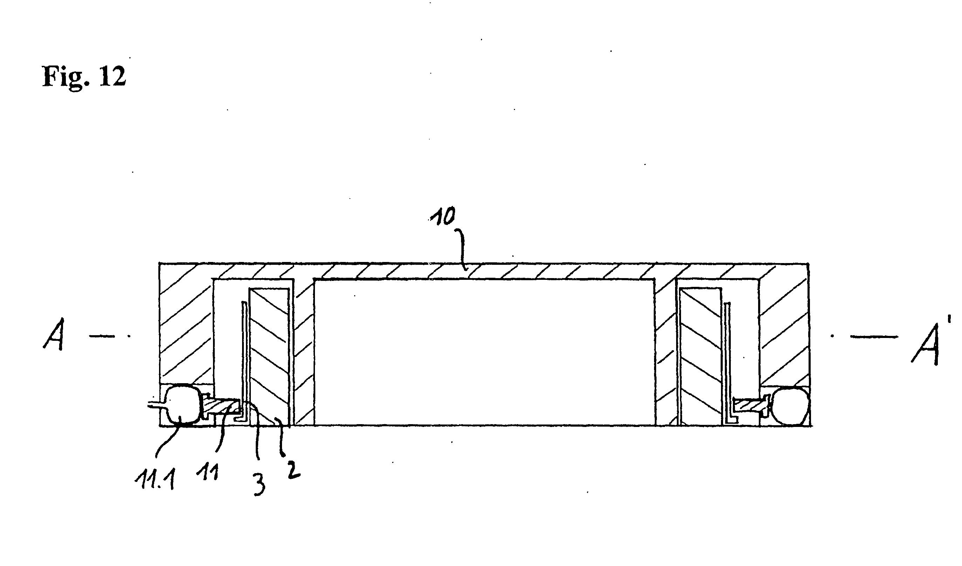

In den Figuren 11 und 12 ist ein vorteilhaftes Ausführungsbeispiel einer erfindungsgemäßen Vorspannvorrichtung 10 gezeigt, die ein Vorspannen und Entspannen der elastischen Spannelemente der erfindungsgemäßen Spannrahmen ermöglicht. Die Vorspannvorrichtung besteht aus einer Rahmenkonstruktion mit verbundenen Kraftübertragungsmitteln für ein Vorspannen der elastischen Spannelemente des Spannrahmens. Bei einem vorteilhaften Ausführungsbeispiel ist die Vorspannvorrichtung als Rahmenkonstruktion mit nach unten offenen U-förmigen Rahmenprofilen ausgebildet, wobei die U-förmige Öffnung für ein Aufsetzen der Vorspannvorrichtung auf den Spannrahmen und eine Aufnahme des 10 Spannrahmens dimensioniert ist. Die inneren Wände der Rahmenkonstruktion des Vorspannmittels liegen dabei wenigstens den Innenseiten der elastische Spannelemente tragenden Rahmenprofile des Spannrahmens an. Die Außenwände der Rahmenkonstruktion des Vorspannmittels enthalten integrierte Kraftübertragungsmittel 11, die für das Vorspannen der elastischen Spannelemente des Spannrahmens nach Innen versetzbar sind.

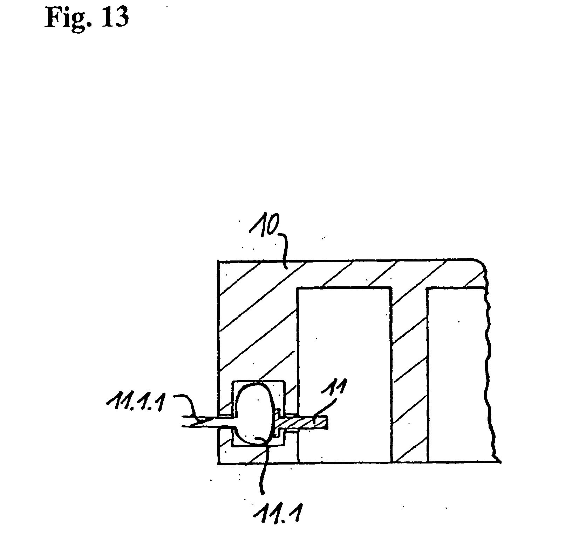

Die Kraftübertragungsmittel 11 können in einer beliebigen, für den Fachmann aufgrund seines Fachwissens auffindbaren Ausgestaltung ausgebildet sein. In Figur 13 ist ein erstes vorteilhaftes Ausführungsbeispiel einer Vorspannvorrichtung mit einem pneumatischen Kraftübertragungsmittel 11.1 gezeigt. Das pneumatische Kraftübertragungsmittel 11.1 ist in vorbestimmter Weise ausgebildet, um eine vorbestimmte Anzahl von Kolben 11 oder eine bewegliche Leiste 11 mittels pneumatischen Drucks in Richtung zu dem verbundenen Spannrahmen hin zu versetzen und die elastischen Spannelemente in Richtung zu dem Rahmenprofil 2 25 hin vorzuspannen. Das pneumatische Kraftübertragungsmittel 11.1 ist vorzugsweise als in der äußeren Wand der Rahmenkonstruktion umlaufender, ringförmig geschlossener Druckluftschlauch ausgebildet, der über ein nach außen geführtes Ventil 11.1.1 mit Druckluft beaufschlagbar ist.

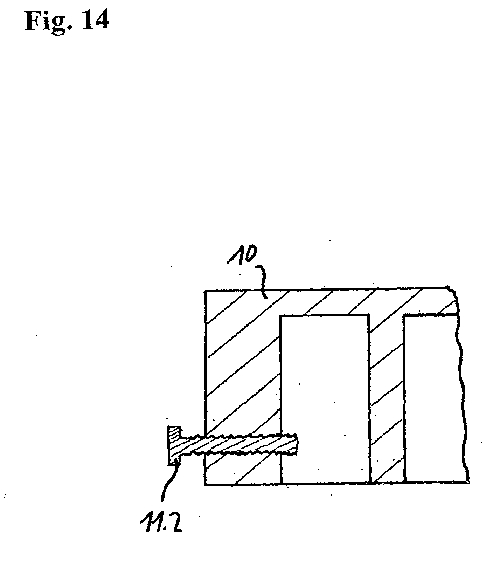

In der Figur 14 ist ein weiteres Ausführungsbeispiel einer Vorspannvorrichtung 10 mit einem mechanischen Kraftübertragungsmittel lediglich rein schematisch dargestellt. Eine von der Außenseite durch ein Gewinde in der Außenwand der Rahmenkonstruktion geführte Schraube 11.2 deutet eine beliebige, vom Fachmann aufgrund seines Fachwissens ohne weiteres auffindbare mechanische Kraftübertragungsvorrichtung an, die in vielfältiger Weise ausgeführt sein kann und eine Vorspannung von elastischen Spannmitteln 3 eines Spannrahmens bewirken kann, der wie in Figur 12 gezeigt, mit der Vorspannvorrichtung verbunden ist.

Die erfindungsgemäßen Vorspannvorrichtungen mit pneumatischen oder mechanischen Kraftübertragungsmitteln sind vorteilhafter Weise an ein steuerbares dosiertes Vorspannen und Entspannen der elastischen Spannelemente der erfindungsgemäßen Spannrahmen angepasst. Die erfindungsgemäßen Vorspannvorrichtungen erlauben ein Vorspannen und Entspannen von Spannelementen von Spannrahmen die mit einer Druckschablone verbunden sind und sind an eine leichte Handhabbarkeit bei dem Wechseln von Druckschablonen angepasst.

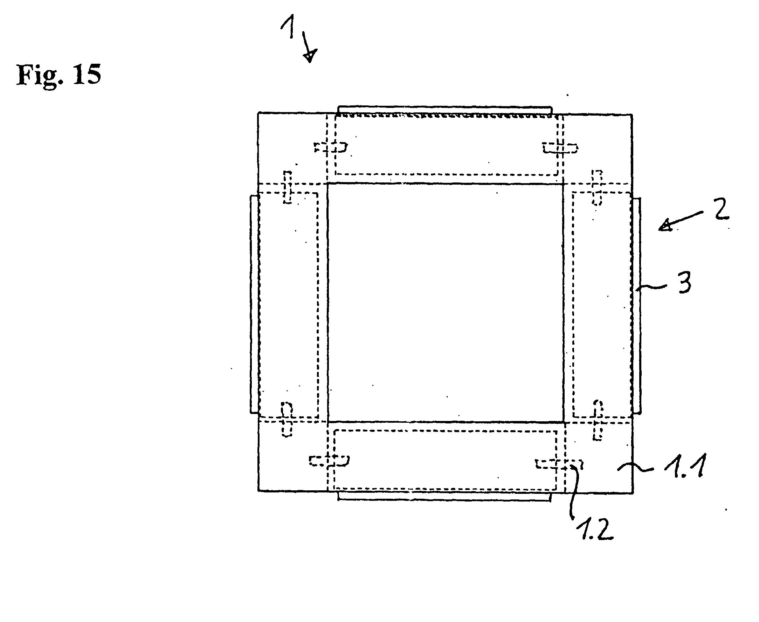

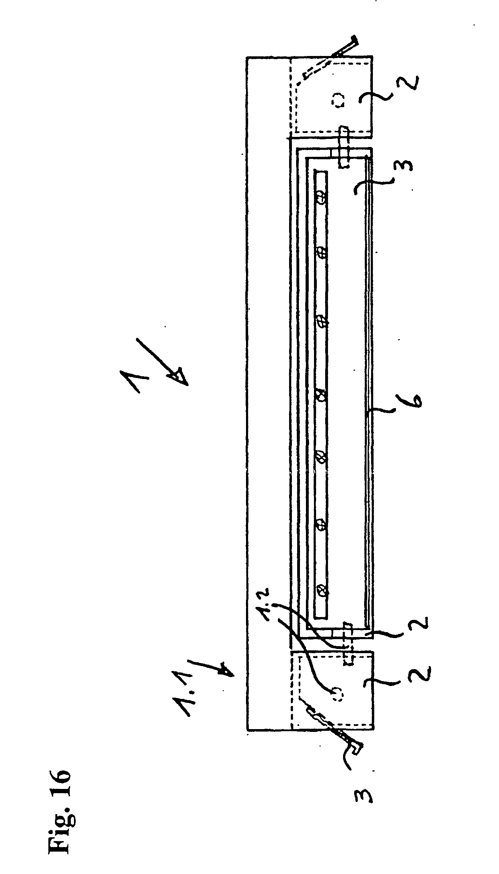

Die Figuren 15 und 16 zeigen in rein schematischer Darstellung Ausführungsbeispiele von erfindungsgemäßen Spannrahmen 1 mit beweglichen, Spannelemente tragenden Rahmenprofilen 2. Wenigstens zwei gegenüberliegende Rahmenprofile 2 mit elastischen Spannelementen 3 sind zwischen Eckabschnitten 1.1 des Spannrahmens in Richtung zu der Rahmeninnenseite hin verschiebbar oder um ihre Längsachse drehbar gelagert. Die beweglichen Rahmenprofile 2 sind mittels Lagerungen 1.2 mit benachbarten Eckabschnitten 1.1 verbunden. die eine Drehung oder ein Verschieben der beweglichen Rahmenprofile ermöglichen.

Die Figur 15 zeigt einen erfindungsgemäßen Spannrahmen 1 mit beweglichen, verschiebbaren oder drehbaren Rahmenprofilen 2 in der Aufsicht von oben. Diebeweglichen Rahmenprofilen 2 sind gestrichelt angedeutet und an wenigstens zwei gegenüberliegenden Seiten des Spannrahmens angeordnet. Auch die rein schematisch angedeuteten Lagerungen 1.2, die an beiden Seiten der beweglichen Rahmenprofile angeordnet sind und die beweglichen Rahmenprofile mit benachbarten Eckabschnitten 1.2 des Spannrahmens verbinden, sind gestrichelt dargestellt. Die elastischen Spannmittel 3 überragen die äußeren Ränder der Spannvorrichtung in einer ersten Position der beweglichen Rahmenprofile.

Die Figur 16 zeigt den Spannrahmen aus Figur 15 in seitlicher Ansicht.

Die beweglichen Rahmenprofile sind zwischen wenigstens zwei Positionen beweglich. In einer ersten Position der beweglichen Rahmenprofile weisen die verbundenen elastischen Spannmittel 3 nach außen. Eine (in den Figuren 15 und 16 nicht gezeigte) mit wenigstens zwei gegenüberliegenden Spannmitteln verbundene Druckschablone ist in der besagten ersten Position durch die elastische, lösbare Verbindung zwischen den Eingriffsmitteln 6 der elastischen Spannmittel und den Profilleisten 4 der Druckschablone gespannt. Die beweglichen Rahmenprofile sind wenigstens in der ersten Position mittels nicht gezeigter Arretierungsmittel arretierbar. Die Arretierung in der ersten Position weist eine ausreichende Festigkeit auf, um der Zugspannung der gespannten Druckschablone Stand zu halten.

Die Arretierung in der ersten Position der beweglichen Rahmenprofile ist lösbar, und die beweglichen Rahmenprofile sind mittels der Lagerungsmittel und weiterer nicht gezeigter Bewegungsmittel in Richtung zur Rahmeninnenseite hin in eine zweite Position verschiebbar oder drehbar. In der zweiten Position sind die elastischen Spannmittel entspannt und die Verbindung der Eingriffsmittel mit den Profilleisten ist gelöst. Die Druckschablone kann ausgewechselt werden.

Die rein schematisch beschriebenen Lagerungen 1.2, Arretierungsmittel und Bewegungsmittel, sowie zusätzliche Kraftübertragungsmittel für das Vorspannen der elastischen Spannmittel sind in vielfältigen Ausführungen vom Fachmann ohne erfinderisches Zutun, alleine aufgrund seines Fachwissens auffindbar und Teil der vorliegenden Erfindung.

Die Erfindung umfasst auch ein Verfahren zum Spannen einer erfindungsgemäßen Druckschablone mittels eines erfindungsgemäßen Spannrahmens mit einem ersten Schritt, bei dem elastische Spannmittel 3 an wenigstens zwei gegenüberliegenden Rahmenprofilen 2 des Spannrahmens vorgespannt werden, wobei insbesondere eine erfindungsgemäße Vorspannvorrichtung verwendet wird oder bewegliche Rahmenprofile eines erfindungsgemäßen Spannrahmens in Richtung zur Rahmenmitte hin verschoben oder gedreht werden; und einem zweiten Schritt, bei dem der Spannrahmen auf eine Druckschablone mit wenigstens zwei an gegenüberliegenden Rändern angeordneten, parallelen Profilleisten aufgesetzt wird; und einem dritten Schritt, bei dem die Vorspannung der Spannmittel verringert wird, bis die Spannmittel unter Vorspannung in die Profilleisten eingreifen und die Druckschablone im wesentlichen plan gespannt halten. Bei dem dritten Schritt wird der Druck der Kraftübertragungsmittel der Vorspannvorrichtung vorzugsweise in dosierter Weise verringert, oder die beweglichen Rahmenprofile werden mittels mit dem Rahmen fest oder lösbar verbundener Kraftübertragungsmittel in Richtung zur Rahmenaußenseite hin verschoben und in ihrer ersten Position, in der die Druckschablone gespannt ist, arretiert.

Erfindungsgemäß ist das Verfahren zum Spannen einer Druckschablone für ein Wechseln der Schablone umkehrbar, wobei das Verfahren in umgekehrter Reihenfolge ausgeführt wird.

Die Erfindung umfasst auch die Verwendung eines erfindungsgemäßen Spannrahmens mit einer erfindungsgemäßen Druckschablone für einen Auftrag von pastosen Materialien auf Träger, insbesondere für den Auftrag von Lotpaste auf elektronische Leiterplatten.

Die erfindungsgemäßen Spannrahmen erlauben ein Spannen der Druckschablonen weitgehend plan in einer Ebene. Dadurch wird ein Spannen von Schablonenfolien beliebiger Stärke möglich, wobei die Probleme des Standes der Technik verhindert werden. Insbesondere wird durch die erfindungsgemäß auf der Schablonenfolie angeordneten, fest verbundenen Profilleisten eine Spannen von dünnen Folien und Kunststofffolien ermöglicht, das mit den bekannten Spannrahmen, deren Spannmittel in randliche Durchbrechungen der Folie eingreifen, wegen der hohen Zugspannung nicht möglich ist.

Die erfindungsgemäß auch vieleckig, insbesondere achteckig ausgebildeten Spannrahmen ermöglichen ein gleichmäßigeres Spannen der Schablonenfolien, als dies im Stand der Technik möglich ist. Dies ist insbesondere auch bei einem Spannen dünner Schablonenfolien und von Kunststofffolien von Vorteil. Schließlich ermöglichen vieleckige Spannrahmen eine Materialersparnis bei den Rahmenprofilen des Spannrahmens, weil die einzelnen Rahmenprofile kürzer bemessen sind und eine geringere Stärke aufweisen müssen, um der Zugspannung der Schablone Stand zu halten.

Bevorzugte Ausführungsformen der Erfindung:
- 1.: Spannrahmen 1 mit wenigstens zwei gegenüberliegenden Rahmenprofilen 2 mit elastischen Spannmitteln 3 für einen lösbaren Eingriff in parallele Profilleisten 4, die an gegenüberliegenden Rändern 5.1 einer Druckschablone 5 in fester Verbindung angeordnet sind.
- 2.: Spannrahmen nach der Ausführungsform 1 mit wenigstens einem elastischen Spannmittel 3 mit einem Eingriffsmittel 6, das korrespondierend zu einer Profilleiste der Druckschablone ausgebildet ist.
- 3.: Spannrahmen nach der Ausführungsform 2 mit Eingriffsmitteln 6, die beim Eingriff in die Profilleisten der Druckschablone im wesentlichen in einer Ebene mit Seiten 2.1 von Rahmenprofilen angeordnet sind, die der Schablone anliegen.
- 4.: Spannrahmen nach einer oder mehreren der Ausführungsformen 1 bis 3 mit an Außenseiten 2.2 von Rahmenprofilen angeordneten, elastischen Spannmitteln.
- 5.: Spannrahmen nach der Ausführungsform 4 mit Rahmenprofilen mit Ausnehmungen 2.3 zur Aufnahme von Abschnitten 4.1 von Profilleisten der Druckschablone.
- 6.: Spannrahmen nach einer oder mehreren der Ausführungsformen 1 bis 5 mit wenigstens einem Rahmenprofil mit wenigstens zwei elastischen Spannmitteln.
- 7.: Spannrahmen nach einer oder mehreren der Ausführungsformen 4 bis 6 mit wenigstens einem als Blattfeder ausgebildeten elastischen Spannmittel, deren oberer Abschnitt 3.1 fest mit einem oberen Abschnitt 2.2.1 eines Rahmenprofils verbunden ist und deren unterer Abschnitt 3.2 in entspanntem Zustand von einem unteren Abschnitt 2.2.2 des Rahmenprofils beabstandet ist.
- 8.: Spannrahmen nach der Ausführungsform 7 mit wenigstens einem elastischen Spannmittel mit wenigstens zwei übereinander liegend angeordneten Blattfedern.
- 9.: Spannrahmen nach einer oder mehreren der Ausführungsformen 4 bis 8 mit wenigstens einem elastischen Spannmittel 3 mit einem Spannprofil 7, dessen oberer Abschnitt 7.1 mit dem oberen Abschnitt 2.2.1 des Rahmenprofils fest verbunden ist und dessen unterer beweglicher Abschnitt 7.2 mittels eines mit dem Rahmenprofil verbundenen Federmittels 8 vorgespannt ist.
- 10.: Spannrahmen nach der Ausführungsform 9 mit wenigstens einem als Blattfeder ausgebildeten Spannprofil, dessen oberer Abschnitt 7.1 fest mit dem Rahmenprofil verbunden ist.
- 11.: Spannrahmen nach der Ausführungsform 9 oder 10 mit wenigstens einem Spannprofil, dessen oberer Abschnitt 7.1 mittels eines Gelenks 9 mit dem Rahmenprofil verbunden ist.
- 12.: Spannrahmen nach einer oder mehreren der Ausführungsformen 1 bis 11 in rechteckiger Ausführung mit zwei gegenüberliegenden Rahmenprofilen mit elastischen Spannmitteln.
- 13.: Spannrahmen nach einer oder mehreren der Ausführungsformen 1 bis 12 in rechteckiger Ausführung mit vier Rahmenprofilen mit elastischen Spannmitteln.
- 14.: Spannrahmen nach einer oder mehreren der Ausführungsformen 1 bis 11 in Form eines Vielecks mit wenigstens zwei gegenüberliegenden Rahmenprofilen mit elastischen Spannmitteln.
- 15.: Spannrahmen nach der Ausführungsform 14 mit einem ersten Paar von gegenüberliegenden Rahmenprofilen mit elastischen Spannmitteln und wenigstens einem zweiten Paar von gegenüberliegenden Rahmenprofilen mit elastischen Spannmitteln, wobei das erste und das zweite Paar einen vorbestimmten Winkel einschließen.
- 16.: Spannrahmen nach der Ausführungsform 14 oder 15 in Form eines Achtecks.
- 17.: Spannrahmen nach der Ausführungsform 16 mit wenigstens zwei, einen Winkel von 90° Grad einschließenden Paaren von gegenüberliegenden Rahmenprofilen mit elastischen Spannmitteln.
- 18.: Spannrahmen nach der Ausführungsform 16 oder 17 mit acht Rahmenprofilen mit elastischen Spannmitteln.
- 19.: Spannrahmen mit Druckschablone 5 nach einer oder mehreren der Ausführungsformen 1 bis 18, wobei an der Druckschablone Profilleisten 4 mit spitzwinkeligem oder im wesentlichen U-förmigem Querschnitt vorgesehen sind.
- 20.: Spannrahmen nach der Ausführungsform 19, wobei die Druckschablone aus Metall, mit fest verbundenen Profilleisten aus Metall oder Kunststoff besteht.
- 21.: Spannrahmen nach der Ausführungsform 19, wobei die Druckschablone aus Kunststoff, mit aufgeklebten Profilleisten aus Metall oder Kunststoff besteht.
- 22.: Spannrahmen nach Ausführungsform 21, wobei die Druckschablone aus einer Polyimidfolie besteht.
- 23.: Spannrahmen nach einer oder mehreren der Ausführungsformen 19 bis 22, wobei der Rohling für die Herstellung der Druckschablone mit einer Schablonenfolie und Profilleisten versehen ist.
- 24.: Spannrahmen mit einer rahmenförmigen Vorspannvorrichtung nach einer oder mehreren der Ausführungsformen 1 bis 18, die mit dem Spannrahmen verbindbar ausgebildet ist und wenigstens ein Kraftübertragungsmittel 11 für ein Vorspannen und Entspannen der elastischen Spannmittel 3 des Spannrahmens aufweist.
- 25.: Spannrahmen nach der Ausführungsform 24, wobei die Vorspannvorichtung pneumatische Kraftübertragungsmittel 11.1 aufweist.
- 26.: Spannrahmen nach der Ausführungsform 24 oder 25, wobei die Vorspannvorrichtung mechanische Kraftübertragungsmittel 11.2 aufweist.
- 27.: Spannrahmen nach einer oder mehreren der Ausführungsformen 1 bis 18 mit wenigstens einem Rahmenprofil 2 mit wenigstens einem elastischen Spannmittel, wobei das Rahmenprofil zwischen zwei Eckabschnitten 1.1 des Spannrahmens verschiebbar in Richtung zur Rahmenmitte gelagert ist und zumindest in einer äußeren Position arretierbar ist.
- 28.: Spannrahmen nach einer oder mehreren der Ausführungsformen 1 bis 18 mit wenigstens einem Rahmenprofil 2 mit wenigstens einem elastischen Spannmittel, wobei das Rahmenprofil zwischen zwei Eckabschnitten 1.1 des Spannrahmens drehbar gelagert ist und zumindest in einer Positionen arretierbar ist, in der das elastische Spannmittel unter Vorspannung in eine Profilleiste einer unter dem Spannrahmen angeordneten Druckschablone eingreift.
- 29.: Verfahren zum Spannen einer Druckschablone 5 nach einer der mehreren der Ausführungsformen 19 bis 23, mittels eines Spannrahmens 1 nach einer oder mehreren der Ausführungsformen 1 bis 18 mit einem ersten Schritt, bei dem elastische Spannmittel 3 an wenigstens zwei gegenüberliegenden Rahmenprofilen 2 des Spannrahmens vorgespannt werden, wobei insbesondere eine Vorspannvorrichtung 7 nach einer oder mehreren der Ausführungsformen 24 bis 26 verwendet wird; einem zweiten Schritt, bei dem der Spannrahmen auf eine Druckschablone 5 mit wenigstens zwei an gegenüberliegenden Rändern angeordneten, parallelen Profilleisten 4 aufgesetzt wird; und einem dritten Schritt, bei dem die Vorspannung der Spannmittel verringert wird, bis die Spannmittel unter Vorspannung in die Profilleisten eingreifen und die Druckschablone im wesentlichen plan gespannt halten.
- 30.: Verfahren zum Auswechseln einer in einen Spannrahmen eingespannten Druckschablone, bei dem das Verfahren nach der Ausführungsform 29 in umgekehrter Reihenfolge durchgeführt wird.
- 31.: Verwendung eines Spannrahmens nach einer oder mehreren der Ausführungsformen 1 bis 18, 27 und 28 mit einer Druckschablone nach einer oder mehreren der Ausführungsformen 19 bis 23 für den Auftrag von Lotpaste auf elektronische Leiterplatten.

Die Erfindung betrifft einen verbesserten Spannrahmen und eine zugehörige Druckschablone für den Auftrag von Stoffen oder Stoffgemischen mit pastenartiger Konsistenz auf Oberflächen von Trägern mittels eines Sieb- oder Schablonendruckverfahrens. Vorzugsweise betrifft die Erfindung einen Spannrahmen für eine Schablone für den Auftrag von Lotpasten auf vorbestimmte Oberflächenbereiche elektronischer Leiterplatten. Bei dem Auftrag wird die Lotpaste mit einer Druckrakel über die mittels des Spannrahmens gespannte Druckschablone gestrichen, wobei die Lotpaste durch Durchbrechungen in der Druckschablone hindurch gepresst wird und auf entsprechende vorbestimmte Flächen auf der Oberfläche einer unter der Druckschablone angeordnete Leiterplatte aufgebracht wird.

Der erfindungsgemäße Spannrahmen besteht zum einen aus miteinander verbundenen Rahmenprofilen. Die Rahmenprofile besitzen vorzugsweise ein geringes Gewicht bei ausreichender Steifigkeit, um leicht handhabbar zu sein und der Zugbelastung beim Spannen einer verbundenen Druckschablone Stand zu halten. Die Rahmenprofile bestehen vorzugsweise aus Aluminium oder aus einer Leichtmetalllegierung oder aus einem Kunststoff mit ausreichender Steifigkeit. Vorzugsweise sind die Rahmenprofile hohl, weisen im wesentlichen rechteckige Querschnitte auf und sind entweder direkt miteinander fest verbunden oder sind an ihren offenen Stirnenden jeweils auf Formteile aus Metall, vorzugsweise Aluminium, oder auf Kunststoffformteile mit geringem Gewicht und ausreichender Festigkeit aufgesteckt, die die Rahmenprofile verbinden und die Ecken des Spannrahmens bilden. Vorzugsweise sind die Rahmenprofile mittels eines Strangpressverfahrens hergestellte Leichtmetallprofile mit vorbestimmten Querschnitten, die vorzugsweise an eine vorteilhafte Befestigung der unten beschriebenen elastischen Spannelemente des Spannrahmens angepasst sind.

Die Unterseiten der Rahmenprofile bilden die Unterseite des Spannrahmens. Bei dem Befestigen und Spannen der Druckschablone liegt die Unterseite des Spannrahmens vorzugsweise weitgehend plan auf der Oberseite, d.h. der Oberfläche, der Druckschablone auf. Bei dem Lotpastenauftrag liegt die Unterseite der gespannten Druckschablone auf der zu bedruckenden Leiterplatte auf.

An der Außenseite wenigstens eines Rahmenprofils des erfindungsgemäßen Spannrahmens ist wenigstens ein elastisches Spannmittel für das Befestigen und das Spannen einer zugehörigen Druckschablone angeordnet. Das elastische Spannmittel ist vorzugsweise mit einem oberen Abschnitt an einem oberen Abschnitt der Außenseite des Rahmenprofils in fester Verbindung angeordnet und weist vorzugsweise einen spannbaren unteren Abschnitt auf, der mit einem unteren Abschnitt des Rahmenprofils einen vorbestimmten Winkel in Richtung zu der Rahmenunterseite hin einschließt und an einen lösbaren Eingriff unter Spannung in eine Profilleiste angepasst ausgebildet ist, die an einem Rand einer zugehörigen Druckschablone angeordnet ist.

Ein elastisches Spannmittel ist vorzugsweise so an der Außenseite eines Rahmenprofils angeordnet, dass ein unterer Abschnitt des elastischen Spannmittels mittels einer Druckkraft, die im wesentlichen in senkrechter Richtung zu dem Rahmenprofil hin gerichtet ist, aus einer im wesentlichen entspannten Anordnung, in der der untere Abschnitt des elastischen Spannmittels in einem vorbestimmten Abstand zu einem unteren Abschnitt des Rahmenprofils angeordnet ist, in Richtung zu dem Rahmenprofil hin ausgelenkt und vorgespannt werden kann.

Dazu ist das elastische Spannmittel vorzugsweise mit einem oberen Abschnitt an einem oberen Abschnitt der Außenseite des Rahmenprofils in fester Verbindung angeordnet. Hierfür wird vorzugsweise eine beliebige ausreichend feste Verbindung, insbesondere mittels Verschrauben, Vernieten, Klemmen, Schweißen, Kleben etc., mit ausreichender Festigkeit gewählt, um das elastische Spannmittel beim Spannen der Druckschablone gegen die an dem unteren Ende des elastischen Spannmittels angreifende Spannkraft mittels seines oberen Abschnitts an dem Rahmenprofil fest zu halten. Die Länge des elastischen Spannmittels entspricht vorzugsweise in etwa der Höhe des Rahmenprofils. Das untere Ende des elastischen Spannmittels ist vorzugsweise im wesentlichen in der Höhe der unteren Kante der Außenseite des Rahmenprofils angeordnet. Das untere Ende des elastischen Spannmittels ist außerdem vorzugsweise mit einem vorbestimmten Abstand von der Unterseite des Spannrahmens angeordnet, der an einen Eingriff des unteren Endes des elastischen Spannmittels in eine Profilleiste mit einem im wesentlichen U-förmigen oder spitzwinkeligen Querschnitt angepasst ist, die mit einer zugehörigen Druckschablone verbunden ist und die Oberfläche der Druckschablone in einer vorbestimmten Höhe überragt.

Der spannbare untere Abschnitt des elastischen Spannmittels ist vorzugsweise nicht mit dem Rahmenprofil verbunden und in einem vorbestimmten seitlichen Abstand zu dem unteren Abschnitt der Außenseite des Rahmenprofils angeordnet. Das elastische Spannmittel schließt vorzugsweise mit der senkrechten Achse des Rahmenprofils einen vorbestimmten spitzen Winkel in Richtung zu der Rahmenunterseite hin ein. Vorzugsweise schließen der untere Abschnitt des elastischen Spannmittels und der untere Abschnitt des Rahmenprofils einen vorbestimmten Winkel in Richtung zu der Rahmenunterseite hin ein, der vorzugsweise an eine ausreichende Auslenkung des unteren Abschnitts des elastischen Spannmittels beim Spannen des elastischen Spannmittels und beim Wechseln der Druckschablone angepasst ist.

Vorzugsweise steht der untere Abschnitt des elastischen Spannmittels von dem Rahmenprofil nach außen hin ab und ist durch Ausüben von Druck in Richtung zu dem Rahmenprofil hin auslenkbar und spannbar. Dabei entsteht eine Spannkraft in dem elastischen Spannmittel, die im wesentlichen in Richtung von dem Rahmenprofil weg nach außen weist. Das untere Ende des elastischen Spannmittels ist an einen lösbaren Eingriff unter Spannung in eine Profilleiste der zugehörigen Druckschablone angepasst ausgebildet.

Die zu dem erfindungsgemäßen Spannrahmen zugehörige Druckschablone trägt Profilleisten für eine lösbare Verbindung mit den elastischen Spannmitteln des Spannrahmens. Die Profilleisten sind an den Rändern der Druckschablone angeordnet und mit der Schablonenfolie fest verbunden. Eine Profilleiste besitzt vorzugsweise einen im wesentlichen U-förmigen oder spitzwinkeligen Querschnitt und besteht vorzugsweise im wesentlichen aus zwei Schenkeln. Die Profilleisten sind so an der Schablonenfolie angeordnet, dass ihre Schenkel in Richtung zu der Schablonenmitte hin weisen und die Öffnungen ihrer im wesentlichen U-förmigen oder spitzwinkeligen Querschnitte der Schablonenmitte zugewandt sind. Die Profilleisten sind vorzugsweise mit einem Schenkel mit der Schablonenfolie fest verbunden, vorzugsweise durch Verschweißen, Vernieten, Klemmen oder Kleben, um der Zugkraft der elastischen Spannmittel des Spannrahmens Stand zu halten. Der fest verbundene Schenkel einer Profilleiste ist vorzugsweise mit der Oberseite der Schablonenfolie, mit einer Kante oder mit der Unterseite der Schablonenfolie fest verbunden und der freie Schenkel der Profilleiste überragt die Schablonenfolie auf der Oberseite der Druckschablone.

Bei dem Befestigen und Spannen einer zugehörigen Druckschablone mit dem erfindungsgemäßen Spannrahmen werden zunächst die unteren Abschnitte der elastischen Spannmittel des Spannrahmens gespannt, indem sie durch Druck von außen in Richtung zu dem Rahmenprofil hin an den unteren Abschnitt des Rahmenprofils angenähert werden. Danach kann der Spannrahmen auf die Oberfläche der zugehörigen Druckschablone aufgesetzt werden, wobei die elastischen Spannmittel mit ihren unteren Abschnitten in die Profilleisten der Druckschablone eingeführt werden können. Anschließend wird die Spannung der elastischen Spannmittel verringert. Dabei werden die Abstände zwischen den Rahmenprofilen und den unteren Abschnitten der elastischen Spannmittel vergrößert, bis die unteren Enden der elastischen Spannmittel unter Spannung in die Profilleisten der Druckschablone eingreifen und die Druckschablone gespannt halten. Der Wechsel der Druckschablone erfolgt in umgekehrter Reihenfolge.

Bei der Befestigung und dem Spannen der erfindungsgemäßen Druckschablone mit dem erfindungsgemäßen Spannrahmen liegt der Spannrahmen auf der Oberfläche der Druckschablone auf, und die Spannmittel des Spannrahmens greifen unter Spannung in die Profilleisten der Druckschablone ein. Durch den Eingriff der elastischen Spannmittel an den Außenseiten der Rahmenprofile in die Profilleisten, die die Oberfläche der Druckschablone überragen, liegt die Druckschablone an der Unterseite des Spannrahmens an und wird erfindungsgemäß nahezu mit ihrer gesamten Fläche gleichförmig und weitgehend plan in einer Ebene gespannt. Vorzugsweise wird die Druckschablone auch in ihren Randbereichen, die Profilleisten tragen, weitgehend plan und in einer Ebene mit der übrigen Schablonenfolie gespannt.

Für eine weitere vorteilhafte Anpassung des unteren Abschnitts eines elastischen Spannmittels an eine Profilleiste einer Druckschablone trägt das elastische Spannmittel vorzugsweise an seinem unteren Ende wenigstens ein nach außen weisendes Eingriffsmittel, das vorzugsweise im Querschnitt haken-, schenkeloder nasenförmig ausgebildet ist. Vorzugsweise ist das Eingriffsmittel im wesentlichen an den Querschnitt einer zugehörigen Profilleiste der Druckschablone angepasst. Vorteilhafterweise verhindert das Eingriffsmittel das Herausrutschen eines elastischen Spannmittels des Spannrahmens aus einer Profilleiste der Druckschablone und ermöglicht beim Spannen eine nahezu senkrechte Anordnung des elastischen Spannmittels an dem Rahmenprofil mit geringer Neigung und eine vorteilhafte große Kraftkomponente der Spannkraft, die von dem elastischen Spannmittel auf die Profilleiste der Druckschablone ausgeübt werden kann.

Vorzugsweise ist ein elastisches Spannmittel als Blattfeder mit ausreichender Elastizität oder als Blattfederstapel mit ausreichender Elastizität für das Spannen der zugehörigen Druckschablone mittels einer vorbestimmten Anzahl von elastischen Spannmitteln des erfindungsgemäßen Spannrahmens ausgebildet. Bei einer bevorzugten Ausführungsform des erfindungsgemäßen Spannrahmens ist der obere Abschnitt einer Blattfeder oder eines Blattfederstapels mit einem oberen Abschnitt der Außenseite eines Rahmenprofils fest verbunden und weist einen unteren spannbaren Abschnitt auf, der nicht mit dem Rahmenprofil verbunden ist. Der untere Abschnitt der Blattfeder ist vorzugsweise in einem vorbestimmten Abstand zu dem Rahmenprofil angeordnet und schließt vorzugsweise mit einem unteren Abschnitt des Rahmenprofils einen vorbestimmten Winkel ein.

Der obere Abschnitt der Blattfeder oder eines Blattfederstapels ist vorzugsweise mit einem oberen Abschnitt der Außenseite eines Rahmenprofils fest verbunden, der als in Richtung zu der Rahmenmitte hin geneigte Fläche ausgebildet ist. Dabei schließen die senkrechte Achse des Rahmenprofils und die Blattfeder in Richtung zu der Unterseite des Rahmenprofils hin einen vorbestimmten spitzen Winkel ein, der vorzugsweise der Neigung des oberen Abschnitts des Rahmenprofils entspricht. Der nicht mit dem Rahmenprofil verbundene untere Abschnitt der Blattfeder schließt mit dem unteren Abschnitt des Rahmenprofils vorzugsweise den gleichen oder einen vorbestimmten Winkel ein, ist in einem vorbestimmten seitlichen Abstand von dem unteren Abschnitt des Rahmenprofils angeordnet und steht vorzugsweise nach außen hin von dem Rahmenprofil ab. Dadurch ist der untere Abschnitt der Blattfeder mittels Druck von außen in Richtung zu dem Rahmenprofil hin auslenkbar und spannbar ausgebildet. Der untere Abschnitt der Blattfeder ist vorzugsweise an einen lösbaren Eingriff unter Spannung in eine Profilleiste der zugehörigen Druckschablone angepasst ausgebildet.

Bei einer weiteren bevorzugten Ausführungsform ist an wenigstens einem Rahmenprofil des erfindungsgemäßen Spannrahmens wenigstens ein im wesentlichen keilförmiges Sockelstück zwischen einem oberen Abschnitt des Rahmenprofils und einem oberen Abschnitt wenigstens eines elastischen Spannmittels, vorzugsweise wenigstens einer Blattfeder oder wenigstens eines Blattfederstapels, angeordnet. Das Sockelstück ist mit oberen Abschnitt des Rahmenprofils und dem oberen Abschnitt des elastischen Spannmittels fest verbunden, vorzugsweise mittels Schrauben, die das elastische Spannmittel an dem Sockelstück und an dem darunter angeordneten Rahmenprofil fest halten.

Das keilförmige Sockelstück schließt in seinem Querschnitt vorzugsweise einen vorbestimmten spitzen Winkel zwischen dem oberen Abschnitt des Rahmenprofils bzw. der senkrechten Achse des Rahmenprofils und der Blattfeder in Richtung zu der Unterseite des Rahmenprofils hin ein. Der über das Sockelstück nach unten hinausragender untere Abschnitt der Blattfeder schließt mit dem unteren Abschnitt des Rahmenprofils vorzugsweise den gleichen oder einen vorbestimmten Winkel ein, ist in einem vorbestimmten seitlichen Abstand von dem unteren Abschnitt des Rahmenprofils angeordnet und steht nach außen hin von dem Rahmenprofil ab. Dadurch ist der untere Abschnitt der Blattfeder mittels Druck von außen in Richtung zu dem Rahmenprofil hin auslenkbar und spannbar.

Bei weiteren bevorzugten Ausführungsformen ist wenigstens ein Rahmenprofil des Spannrahmens mittels eines Strangpressverfahrens, vorzugsweise aus Aluminium, hergestellt und vorzugsweise innen im wesentlichen hohl. Der Querschnitt eines mittels eines Strangpressverfahrens hergestellten Rahmenprofils ist vorzugsweise an eine feste Anordnung wenigstens eines elastischen Spannmittels, vorzugsweise wenigstens einer Blattfeder, an einem oberen Abschnitt des Rahmenprofils angepasst ausgebildet, wobei ein spannbarer unterer Abschnitt des elastischen Spannmittels mit einem unteren Abschnitt der Außenseite des Rahmenprofils einen vorbestimmten Winkel einschließt. Dabei weist das Rahmenprofil vorzugsweise im Schnitt ein Profil auf, das im wesentlichen einem rechteckigen Rahmenprofil mit dem vorstehend beschriebenen, vorzugsweise an dem oberen Abschnitt der Außenseite des Rahmenprofils angeordneten, Sockelstück entspricht oder das im wesentlichen einem rechteckigen Rahmenprofil mit einem als in Richtung zu der Rahmenmitte hin geneigte Fläche ausgebildeten oberen Abschnitt seiner Außenseite entspricht.

Das untere Ende der Blattfeder oder der obersten Blattfeder des Blattfederstapels ist vorzugsweise in Form einer nach außen hin abgewinkelten kurzen Nase ausgebildet und erfüllt die Funktion eines Eingriffsmittels. Dadurch wird das Herausrutschen der Blattfeder aus einer Profilleiste einer zugehörigen Druckschablone verhindert und beim Spannen der Druckschablone eine nahezu senkrechte Anordnung der Blattfeder an dem Rahmenprofil mit geringer Neigung und eine vorteilhafte große Kraftkomponente der Spannkraft ermöglicht, die von der Blattfeder auf eine Profilleiste der Druckschablone ausgeübt werden kann.

Bei einer weiteren bevorzugten Ausführungsform des erfindungsgemäßen Spannrahmens schließen der untere Abschnitt der Außenseite eines Rahmenprofils und die Unterseite des Rahmenprofils im wesentlichen einen vorbestimmten stumpfen Winkel ein, oder der untere Abschnitt des Rahmenprofils bildet mit dessen oberem Abschnitt eine Stufe in Richtung zu der Rahmenmitte hin, so dass der mit dem Rahmenprofil nicht verbundene untere Abschnitt der Blattfeder um eine größere Strecke in Richtung zu dem Rahmenprofil hin ausgelenkt werden kann als bei einem Rahmenprofil mit einem an dessen oberen Abschnitt ohne Stufe anschließenden, im wesentlichen senkrecht ausgebildeten, unteren Abschnitt. Dadurch wird vorteilhafter Weise beim Spannen eine nahezu senkrechte Anordnung der Blattfeder an dem Rahmenprofil mit geringer Neigung und eine vorteilhafte große Kraftkomponente der Spannkraft ermöglicht, die von der Blattfeder auf eine Profilleiste der Druckschablone ausgeübt werden kann.

Der erfindungsgemäße Spannrahmen ist vorzugsweise rechteckig und ermöglicht ein Befestigen der zugehörigen Druckschablone an wenigstens zwei gegenüberliegenden Rahmenprofilen und ein Spannen der Druckschablone in einer Richtung oder vorzugsweise in zwei senkrecht zueinander angeordneten Richtungen. Weitere bevorzugte Ausführungsformen des erfindungsgemäßen Spannrahmens sind vieleckig, vorzugsweise sechseckig oder achteckig, weisen an einer vorbestimmten Anzahl von Rahmenprofilen, vorzugsweise an zwei, vier, sechs oder acht Rahmenprofilen, elastische Spannmittel für korrespondierende Profilleisten an einer vorbestimmten Anzahl von Rändern der zugehörigen Druckschablone, vorzugsweise an zwei, vier, sechs oder acht Rändern der Druckschablone, auf und ermöglichen ein Befestigen und ein Spannen der Druckschablone in einer vorbestimmten Anzahl von Richtungen, vorzugsweise in einer, zwei, drei oder vier Richtungen. Die vieleckigen Spannrahmen ermöglichen erfindungsgemäß ein Spannen der zugehörigen Druckschablonen in einer vorbestimmten Vielzahl von Richtungen und ermöglichen damit vorteilhafter Weise ein Spannen der Druckschablone mit verbesserter Gleichförmigkeit. Außerdem ermöglichen vieleckige Rahmen die Verwendung von kürzeren Rahmenprofilen, die eine geringere Steifigkeit besitzen müssen und deshalb eine Materialersparnis und eine Gewichtsersparnis ermöglichen.

Der erfindungsgemäße Spannrahmen weist wenigstens ein Rahmenprofil mit wenigstens einem elastischen Spannmittel auf, und die zugehörige Druckschablone weist wenigstens eine mit den elastischen Spannmitteln korrespondierende Profilleiste auf. Vorzugsweise sind an den Außenseiten von wenigstens zwei gegenüberliegenden Rahmenprofilen des Spannrahmens elastische Spannmittel angeordnet, die vorzugsweise mit ihren unteren Enden in korrespondierende, im wesentlichen parallele Profilleisten an gegenüberliegenden Rändern der Druckschablone eingreifen können, um die Druckschablone zu befestigen und zu spannen.

Alternativ weist wenigstens ein Rahmenprofil des Spannrahmens wenigstens ein elastisches Spannmittel für wenigstens eine korrespondierende Profilleiste der zugehörigen Druckschablone auf, und das gegenüberliegende Rahmenprofil weist wenigstens ein im wesentlichen starres Befestigungsmittel für den gegenüberliegenden Rand der Druckschablone auf. Vorzugsweise kann die untere Längskante des gegenüberliegenden Rahmenprofils auf der Außenseite einen im Querschnitt haken- oder nasenförmiger Vorsprung tragen, der eine korrespondierende Profilleiste an dem gegenüberliegenden Rand der Druckschablone aufnehmen kann. Alternativ können an dem gegenüberliegenden Rahmenprofil beliebige andere im wesentlichen starre Befestigungsmittel für die Druckschablone ausgebildet sein, beispielsweise eine Nut, in die eine Profilleiste der Druckschablone einführbar ist, eine Klemmvorrichtung für die Schablonenfolie, die vorzugsweise keine Profilleiste der Druckschablone erfordert, eine Befestigungsvorrichtung mit Stiften oder mit einer vorbestimmten Vielzahl von Haken für einen Eingriff in korrespondierende Löcher oder Schlitze in der Schablonenfolie oder beliebige andere im wesentlichen starre Befestigungsmittel, die die Schablone entgegen der Spannkraft der elastischen Spannmittel an dem gegenüberliegenden Rahmenprofil des Spannrahmens in lösbarer fester Verbindung zu halten vermögen.

Vorzugsweise ist an wenigstens einem Rahmenprofil des Spannrahmens eine vorbestimmte Mehrzahl von elastischen Spannmitteln angeordnet, die entweder unmittelbar benachbart oder mit vorbestimmten Abständen benachbart angeordnet sind. Bei einer besonders bevorzugten Ausführungsform des erfindungsgemäßen Spannrahmens sind an den vier Rahmenprofilen des rechteckigen Spannrahmens jeweils eine vorbestimmte Mehrzahl von Blattfedern oder eine vorbestimmte Mehrzahl von Blattfederstapeln im wesentlichen unmittelbar benachbart angeordnet. Vorzugsweise ist dabei jeweils ein im wesentlichen keilförmiges Sockelstück zwischen dem im wesentlichen als senkrechte Fläche ausgebildeten oberen Abschnitt des Rahmenprofils und den oberen Abschnitten der Blattfedern bzw. Blattfederstapeln angeordnet und mit beiden, vorzugsweise mittels Schrauben, fest verbunden. Vorzugsweise sind dabei die spannbaren untere Abschnitte der Blattfedern an ihren unteren Enden jeweils in Richtung nach außen hin im wesentlichen in Form einer kurzen Nase abgewinkelt und erfüllen die Funktion von Eingriffsmitteln.

Die Ausführungsformen des Spannrahmens mit einer Mehrzahl von benachbarten Blattfedern bzw. Blattfederstapeln an gegenüberliegenden Rahmenprofilen besitzen den Vorteil, dass Toleranzen in der parallelen Anordnung der korrespondierenden Spannprofile an gegenüberliegenden Rändern der zugehörigen Druckschablone durch die Mehrzahl der jeweils eingreifenden und spannenden Blattfedern ausgeglichen werden, die dabei unterschiedlich weit ausgelenkt sein können.

Durch die Anordnung von Blattfedern mittels Sockelstücken und Schrauben an den Außenseiten der Rahmenprofile besitzt der erfindungsgemäße Spannrahmen als passiv spannender Spannrahmen eine einfache Konstruktion ohne bewegliche mechanische Teile, die einem Verschleiß ausgesetzt sind, und er kann in unterschiedlichen Formaten kostengünstig hergestellt werden.

Vorzugsweise ist bei der erfindungsgemäßen Druckschablone wenigstens an einem Rand anstelle einer durchgehenden, langen Profilleiste eine vorbestimmte Mehrzahl von benachbarten kurzen Profilleisten angeordnet. Vorzugsweise sind die Anordnungen der kurzen Profilleisten an den Rändern der Druckschablone an die Anordnungen der elastischen Spannmittel an den Rahmenprofil des Spannrahmens angepasst, so dass jeweils eine oder mehrere vorzugsweise als Blattfedern ausgebildete elastische Spannmittel in ein kurze Profilleiste eingreifen. Die kurzen Profilleisten können vorteilhafterweise einfach und im wesentlichen ohne Krümmungen hergestellt werden.

Erfindungsgemäße Druckschablonen für den erfindungsgemäßen Spannrahmen bestehen vorzugsweise aus Schablonenfolien mit ausreichender Zugfestigkeit, Flexibilität, Abriebfestigkeit, mit ausgewählten Stärken für den Auftrag von Lotpasten mit vorbestimmten Schichtdicken auf Leiterplatten und aus Materialien, die in einfacher Weise und mit der erforderlichen Präzision, vorzugsweise mittels Laserschneidens, bearbeitet werden können, um Durchbrechungen für den Lotpastenauftrag in den Schablonenfolien herstellen zu können. Eine Schablonenfolie einer erfindungsgemäßen Druckschablone besteht vorzugsweise aus einer Metallfolie, vorzugsweise einer Edelstahlfolie oder einer mittels eines galvanischen Additivverfahrens hergestellten Nickelschablone mit Durchbrechungen und vorzugsweise mit erfindungsgemäßen Schlitzen, oder einer Kunststofffolie mit hoher Zugfestigkeit, vorzugsweise einer Polyimidfolie. Die Druckschablonen weisen Druckbilder mit wenigstens einer vollständigen Durchbrechung der Schablonenfolie für den Auftrag von Lotpaste auf. Die Durchbrechungen in den Schablonenfolien aus Metall sind vorzugsweise mittels Ätzverfahren und/oder mittels Ausschneiden mit Laser und/oder mit einem galvanischen Additivverfahren hergestellt.

Bei der Herstellung sog. "Electro-formed Stencils" mittels eines galvanischen Additivverfahrens wird vorzugsweise die gesamte Schablonenfolie galvanisch aufgebaut. Bei einem galvanischen Aditiwerfahren wird im wesentlichen in einem ersten Schritt Fotolack auf die Oberfläche einer geerdeten Basisplatte aus Metall aufgebracht. In einem zweiten Schritt werden die Oberflächenbereiche mit dem Fotolack belichtet und gehärtet, an denen die Durchbrechungen und vorzugsweise auch die Schlitze der erfindungsgemäßen Druckschablonen ausgebildet werden sollen. In einem dritten Schritt wird der nicht gehärtete Fotolack von den nicht belichteten Oberflächenbereichen abgewaschen. In einem vierten Schritt wird in einem galvanischen Bad eine Nickelschicht mit vorbestimmter Stärke auf den nicht mit dem Fotolack bedeckten Oberflächenbereichen der geerdeten Basisplatte abgeschieden. In einem vierten Schritt wird die Nickelschicht als Schablonenfolie mit vorbestimmter Stärke, vorbestimmten Durchbrechungen und vorzugsweise mit erfindungsgemäßen Schlitzen in ausgewählten Randbereichen von der Basisplatte abgenommen.

Bei vorteilhaften Ausführungsformen weisen die Druckschablonen eine Mehrzahl von Bereichen mit vorbestimmten, unterschiedlichen Stärken für den Auftrag von Lotpaste in vorbestimmten, unterschiedlichen Schichtdicken auf vorbestimmte Bereiche von Leiterplatten auf.

Die Profilleisten der erfindungsgemäßen Druckschablonen bestehen vorzugsweise aus Metall, insbesondere aus Edelstahl, und sind vorzugsweise mittels Stanzverfahren oder Prägeverfahren hergestellt. Bevorzugte Druckschablonen weisen eine Mehrzahl von kurzen Profilleisten auf, die längs wenigstens eines Randes der Druckschablone mit vorbestimmten Abständen, vorzugsweise nahe beabstandet, angeordnet sind. Profilleisten aus Edelstahl sind vorzugsweise mit einer Schablonenfolie aus Edelstahl oder mit einer Schablonenfolie eines Electro-formed Stencils aus Nickel mittels Laserschweißen verbunden. Alternativ kann eine beliebige andere ausreichend feste Verbindung, insbesondere Vernieten, Kleben oder Klemmen, gewählt werden, um die Profilleisten gegen die Zugkraft der elastischen Spannelemente des Spannrahmens an der Schablonenfolie fest zu halten. Bei einer weiteren bevorzugten Ausführungsform bestehen die Profilleisten vorzugsweise aus Edelstahl oder aus Kunststoff und weisen wenigstens einen ausreichend breiten Schenkel auf, der auf eine Schablonenfolie aus Metall oder Kunststoff mittels eines Klebers mit ausreichender Zugfestigkeit aufgeklebt ist.

Bei einer besonders bevorzugten Ausführungsform der erfindungsgemäßen Druckschablone ist an wenigstens einem Rand der Druckschablone jeweils eine vorbestimmte Mehrzahl von benachbarten kurzen Profilleisten mit vorbestimmten Längen in fester Verbindung angeordnet. Die kurzen Profilleisten sind entlang eines Randes der Druckschablone vorzugsweise mit geringen Abständen zueinander benachbart angeordnet. Jeweils zwischen zwei benachbarten kurzen Profilleisten ist vorzugsweise ein schmaler, die Schablonenfolie vorzugsweise in ihrer gesamten Stärke durchdringender Schlitz oder eine entsprechende Materialschwächung ausgebildet, der sich in der Zugrichtung, d.h. in senkrechter Richtung zu den kurzen Profilleisten, von der äußeren Kante der Schablonenfolie mit einer vorbestimmten Länge erstreckt. Vorzugsweise ist der Schlitz in der Schablonenfolie als im wesentlichen gerader Schnitt mit vorbestimmter Länge, vorzugsweise mittels Laserschneidens, hergestellt.

Die Schlitze erstrecken sich mit vorbestimmten, vorzugsweise gleichen, Längen innerhalb wenigstens eines Randbereichs einer Druckschablone mit einer vorbestimmten Breite, der vorzugsweise außerhalb eines mittleren Bereichs der Druckschablone liegt, in dem die Durchbrechungen eines Druckbilds angeordnet sind oder bei einem Rohling anordenbar sind. Die Länge der Schlitze ist außerdem erfindungsgemäß daran angepasst, ein vorteilhaftes Verteilen der Zugkräfte, die an den kurzen Profilleisten angreifen, auf die Schablonenfolie und ein Spannen der Schablone mit verbesserter Gleichförmigkeit zu ermöglichen.

Die erfindungsgemäße Druckschablone weist vorzugsweise keine Profilleisten in den Bereichen ihrer Ecken auf, die vorzugsweise abgeschnitten sein können. Der erfindungsgemäße Spannrahmen weist vorzugsweise keine elastischen Spannelemente in den Bereichen seiner Ecken auf. Bei vorteilhaften Ausführungsformen der erfindungsgemäßen Druckschablone überragen die Profilleisten mit ihren äußeren Kanten die Kanten der Schablonenfolie. Dabei besitzt die Druckschablone vorteilhafter Weise keine scharfen Kanten und ermöglicht eine sichere Handhabung.

Die Druckschablone für den erfindungsgemäßen Spannrahmen weist Durchbrechungen in der Schablonenfolie für den Durchtritt der Lotpaste während des Druckvorgangs auf. Die Erfindung umfasst jedoch auch einen erfindungsgemäßen Rohling für die Herstellung der Druckschablone. Der Rohling besteht vorzugsweise im wesentlichen aus der gleichen Schablonenfolie und besitzt vorzugsweise im wesentlichen die gleichen Profilleisten wie die Druckschablone, aber er weist noch keine oder noch nicht sämtliche Durchbrechungen in der Schablonenfolie auf. Für die Herstellung der Durchbrechungen wird der Rohling mittels des Spannrahmens im wesentlichen in der gleichen Weise gespannt wie die Druckschablone, und an vorbestimmte Flächen der gespannten Schablonenfolie werden Durchbrechungen hergestellt. Vorzugsweise werden die Durchbrechungen mittels Lasers aus einer Schablonenfolie aus Edelstahl ausgeschnitten. Bei weiteren bevorzugten Ausführungen sind die Schablonenfolien Kunststofffolien mit hoher Zugfestigkeit, insbesondere Polyimidfolien. Durch das Spannen der Rohlinge wird bei den erfindungsgemäßen Druckschablonen eine verbesserte Präzision bei der Herstellung der Durchbrechungen in der Schablonenfolie erreicht.

Die Erfindung umfasst die Verwendung der erfindungsgemäßen Druckschablone oder von weiteren geeigneten Druckschablonen mit wenigstens einer die Schablonenoberfläche überragenden Profil-, Befestigungs- oder Spannleiste oder mit wenigstens einer im wesentlichen die Schablonenoberfläche überragenden, umgebogenen Kante, die mit einem erfindungsgemäßen Spannrahmen gespannt werden kann, für ein Befestigen an dem erfindungsgemäßen Spannrahmen, für ein Spannen mit dem erfindungsgemäßen Spannrahmen und, bei Sieb- oder Schablonendruckverfahren, vorzugsweise für den Auftrag von Lotpasten auf elektronische Leiterplatten.

Die Erfindung betrifft außerdem eine Vorspannvorrichtung für den erfindungsgemäßen Spannrahmen, die das Wechseln der zugehörigen Druckschablone erleichtert. Vorzugsweise weist die Vorspannvorrichtung wenigstens eine Öffnungen mit im wesentlichen U-förmigen Querschnitt auf, die an die Aufnahme eines Rahmenprofils des zugehörigen Spannrahmens mit wenigstens einem elastischen Spannmittel angepasst ist. Bei einer bevorzugten Ausführungsform ist die Vorspannvorrichtung im wesentlichen rechteckig ausgebildet und weist in ihren Randbereichen Öffnungen für die Aufnahme der Rahmenprofile eines rechteckigen Spannrahmens mit elastischen Spannmitteln auf.

Die Vorspannvorrichtung ist vorzugsweise an eine Anordnung auf der Oberfläche einer Werkbank angepasst, wobei die Öffnungen der Vorspannvorrichtung vorzugsweise seitliche und untere Begrenzungen aufweisen und ein Einsetzen des Spannrahmens von oben ermöglichen, wobei die Unterseite des Spannrahmens nach dem Einsetzen in die Vorspannvorrichtung vorzugsweise nach oben weist.

Die erfindungsgemäße Vorspannvorrichtung weist wenigstens ein Kraftübertragungsmittel für ein Spannen und Entspannen der elastischen Spannelemente des zugehörigen Spannrahmens auf. Ein Kraftübertragungsmittel umfasst vorzugsweise wenigstens einen Druckschlauch, vorzugsweise einen Druckluftschlauch, und wenigstens ein bewegliches Kraftübertragungsmittel, insbesondere wenigstens einen Kolben oder eine bewegliche Leiste.

Bei einer ersten bevorzugten Ausführungsform ist wenigstens ein bewegliches Kraftübertragungsmittel innerhalb einer Öffnung der Vorspannvorrichtung an einer seitlichen Begrenzung der Öffnung angeordnet. Das bewegliche Kraftübertragungsmittel ist an der seitlichen Begrenzung vorzugsweise so angeordnet, dass es eine vorbestimmte Druckkraft im wesentlichen in senkrechter Richtung auf die Innenseite eines in die Öffnung eingesetzten Rahmenprofils eines Spannrahmens oder auf mit der Außenseite des Rahmenprofils verbundene elastische Spannmittel ausüben kann. Dazu ist das bewegliche Kraftübertragungsmittel vorzugsweise an der inneren seitlichen Begrenzung bzw. an der äußeren seitlichen Begrenzung der Öffnung beweglich angeordnet und in seitlicher Richtung zu dem Rahmenprofil hin versetzbar ausgebildet.

Vorzugsweise ist ein bewegliches Kraftübertragungsmittel so ausgebildet, dass es die Druckkraft im wesentlichen auf den spannbaren unteren Abschnitt eines elastischen Spannmittels ausübt, der nicht mit dem Rahmenprofil verbunden ist, in entspanntem Zustand in einem vorbestimmten Abstand zu dem unteren Abschnitt des Rahmenprofils angeordnet ist und von dem unteren Abschnitt des Rahmprofils nach außen hin absteht, um den unteren Abschnitt des elastischen Spannmittels in Richtung zu dem Rahmenprofil hin auszulenken und zu spannen.

Vorzugsweise ist innerhalb der Öffnung zusätzlich zu den beweglichen Kraftübertragungsmitteln an der äußeren Begrenzung der Öffnung wenigstens ein weiteres bewegliches Kraftübertragungsmittel an der inneren Begrenzung angeordnet, das eine Druckkraft auf die Innenseite des Rahmenprofils ausüben kann, um der Druckkraft der gegenüberliegenden beweglichen Kraftübertragungsmittel auf die elastischen Spannmittel des Rahmenprofils entgegenzuwirken und vorteilhafter Weise Verformungen des Rahmenprofils beim Spannen der elastischen Spannelemente und beim Wechseln der Druckschablone zu vermeiden.

Vorzugsweise sind die beweglichen Kraftübertragungsmittel als bewegliche Leisten ausgebildet, die innerhalb einer Öffnung der Vorspannvorrichtung jeweils mittels einer Lagerung an einer seitlichen Begrenzung der Öffnung beweglich gelagert sind. Bei bevorzugten Vorspannvorrichtungen, die ein Einsetzen des Spannrahmens von oben ermöglichen, so dass die Unterseite des Spannrahmens nach dem Einsetzen in die Vorspannvorrichtung nach oben weist, weist eine bewegliche Leiste eines Kraftübertragungsmittels ein versetzbares oberes Ende und vorzugsweise ein unterhalb der Lagerung angeordnetes, in der entgegengesetzten Richtung zu dem oberen Ende versetzbares unteres Ende auf.

Für ein Versetzen des oberen Endes einer beweglichen Leiste, um ein elastisches Spannmittel des Rahmenprofils vorzuspannen, ist vorzugsweise in einem unteren Abschnitt der Öffnung ein Druckschlauch, vorzugsweise ein mit Druckluft beaufschlagbarer Druckluftschlauch, angeordnet, um einen Druck mit vorbestimmter Größe in der entgegengesetzten Richtung auf das unterhalb der Lagerung der beweglichen Leiste angeordnete untere Ende der Leiste auszuüben. Vorzugsweise sind an den unteren Enden der Leisten zusätzlich Federmittel angeordnet, die auf die beweglichen Leisten vorzugsweise eine vergleichsweise geringe Zugkraft ausüben, die im wesentlichen in der entgegengesetzten Richtung zu der von dem Druckschlauch auf die unteren Enden der Leisten ausgeübten Druckkraft gerichtet ist und ein Zurückversetzen der beweglichen Leisten bewirkt, wenn der Druck in dem Druckschlauch abgelassen wird.

Vorzugsweise sind die beweglichen Leisten in einer zangenartigen Anordnung an den gegenüberliegenden seitlichen Begrenzungen der Öffnung angeordnet, wobei ein Druckluftschlauch zwischen den unteren Enden der beweglichen Leisten angeordnet ist. Vorzugsweise ist die Länge einer beweglichen Leiste an die Länge eines Abschnitts eines Rahmenprofils des zugehörigen Spannrahmens angepasst, der elastische Spannmittel trägt.

Bei einer weiteren bevorzugten Ausführungsform der erfindungsgemäßen Vorspannvorrichtung ist wenigstens die äußere seitliche Begrenzung einer Öffnung als bewegliche Leiste des Kraftübertragungsmittels ausgebildet. Vorzugsweise sind die äußere und die innere seitliche Begrenzung wenigstens einer Öffnung als bewegliche Leisten in einer zangenförmigen Anordnung ausgebildet und mittels Lagerungen an ihren Innenseiten beweglich mit einem zwischen den beweglichen Leisten angeordneten Lagerungsprofil der Vorspannvorrichtung verbunden. Vorzugsweise bildet das Lagerungsprofil eine untere Begrenzung der Öffnung. Vorzugsweise erstrecken sich die unteren Enden der beweglichen Leisten bis unterhalb des zwischen den Leisten angeordneten Lagerungsprofils und sind in den entgegengesetzten Richtungen zu den oberen Enden der beweglichen Leisten versetzbar ausgebildet. Vorzugsweise ist zwischen den unteren Enden der beweglichen Leisten oder zwischen der inneren Begrenzung der Öffnung und der äußeren beweglichen Leiste ein Druckschlauch angeordnet, um eine Druckkraft auf die unteren Enden der beweglichen Leisten und in der umgekehrten Richtung mittels der oberen Enden der beweglichen Leisten auf ein Rahmenprofil in der Öffnung der Vorspannvorrichtung auszuüben.

Das Lagerungsprofil ist in geeigneter Weise mit der Vorspannvorrichtung fest verbunden. Vorzugsweise weist ein Lagerungsprofil eine größere Länge als die zugehörige Öffnung der Vorspannvorrichtung auf und ist an seinen Enden mit den Ecken der Vorspannvorrichtung fest verbunden.

Die Erfindung umfasst außerdem ein Verfahren zum Spannen der erfindungsgemäßen Druckschablone im wesentlichen in einer Ebene mittels des erfindungsgemäßen Spannrahmens und vorzugsweise mittels der erfindungsgemäßen Vorspannvorrichtung. Dabei werden in einem ersten Schritt die an wenigstens einem Rahmenprofil des erfindungsgemäßen Spannrahmens angeordneten elastischen Spannmittel vorgespannt. Dazu werden die Rahmenprofile des Spannrahmens vorzugsweise von oben in die Öffnungen einer auf einer Werkbank angeordneten Vorspannvorrichtung eingesetzt, so dass danach die Unterseiten der Rahmenprofile nach oben weisen und die Vorspannvorrichtung überragen.

Bei dem Spannen der an den Außenseiten von Rahmenprofilen des Spannrahmens angeordneten elastischen Spannmittel werden die von dem unteren Abschnitt des Rahmenprofils nach außen hin abstehenden unteren Enden der elastischen Spannmittel vorzugsweise mittels der Kraftübertragungsmittel der Vorspannvorrichtung in Richtung zu dem Rahmenprofil hin ausgelenkt und gespannt, wobei die unteren Enden der gespannten elastischen Spannmittel im wesentlichen an den unteren äußeren Längskanten der Rahmenprofile des Spannrahmens anliegen.

In einem zweiten Schritt wird eine erfindungsgemäße zugehörige oder eine geeignete Druckschablone an der Unterseite des Spannrahmens mit den mittels der Vorspannvorrichtung gespannten elastischen Spannmitteln angeordnet. Dazu wird die Druckschablone vorzugsweise von oben auf die Unterseite des Spannrahmens mit den an den Längskanten der Rahmenprofilen anliegenden unteren Enden der gespannten elastischen Spannmittel aufgelegt, so dass die Profilleisten der Druckschablone neben den äußeren Längskanten der Rahmenprofile und den unteren Enden der gespannten elastischen Spannmittel zu liegen kommen. Dabei behindern die elastischen Spannmittel in ihrem gespannten Zustand das Auflegen der Druckschablone mit wenigstens einer, an einem Rand der Schablone angeordneten, vorzugsweise nach unten weisenden, Profilleiste nicht.

Bei einer alternativen Ausführungsform eines erfindungsgemäßen Spannrahmens mit einer zugehörigen Druckschablone, der an wenigstens einem Rahmenprofil elastische Spannmittel für wenigstens eine Profilleiste an einem Rand der Druckschablone und an dem jeweils gegenüberliegenden Rahmenprofil im wesentlichen starre Befestigungsmittel für den gegenüberliegenden Rand der Schablone aufweist, werden in dem zweiten Verfahrensschritt zusätzlich die im wesentlichen starren Befestigungsmittel des Spannrahmens mit der Druckschablone verbunden.

In einem dritten Schritt wird die Druckschablone gespannt. Dazu wird der Druck der Kraftübertragungsmittel der Vorspannvorrichtung verringert, wozu vorzugsweise der Druck in einem Druckschlauch der Vorspannvorrichtung verringert wird. Dabei wird die Spannung der elastischen Spannmittel des Spannrahmens verringert, und die Abstände zwischen den Rahmenprofilen des Spannrahmens und den unteren Abschnitten der elastischen Spannmittel werden vergrößert, bis die elastischen Spannmittel mit ihren unteren Enden, vorzugsweise mit an den Außenseiten angeordneten Eingriffsmitteln, unter Spannung in die Profilleisten der an der Unterseite des Spannrahmens angeordneten Druckschablone eingreifen und die Druckschablone in einer lösbaren Verbindung einschließlich ihrer Randbereiche mit den Profilleisten im wesentlichen in einer Ebene weitgehend plan gespannt halten. Gegebenfalls nach einer weiteren Verringerung des Drucks auf die beweglichen Spannelemente kann der Spannrahmen mit der gespannten Druckschablone aus der Vorspannvorrichtung entnommen werden. Der Wechsel der Schablone erfolgt im wesentlichen in der umgekehrten Reihenfolge.

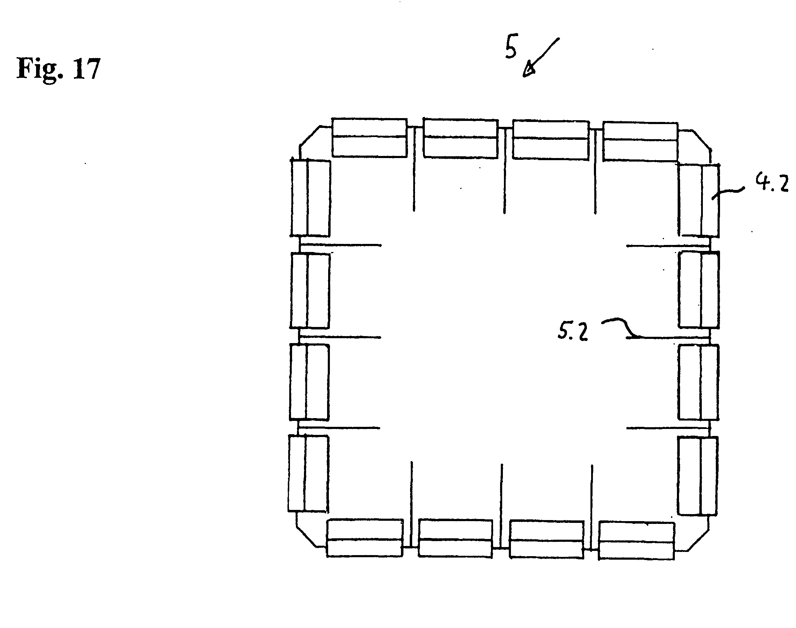

Im folgenden werden weitere vorteilhafte Ausführungsbeispiele des erfindunggemäßen Spannrahmens, der erfindungsgemäßen zugehörigen Druckschablone und der erfindungsgemäßen Vorspannvorrichtung anhand von weiteren Figuren der schematischen Zeichnungen beschrieben. Dabei zeigt die
- Figur 17: eine weitere Druckschablone in der Aufsicht;

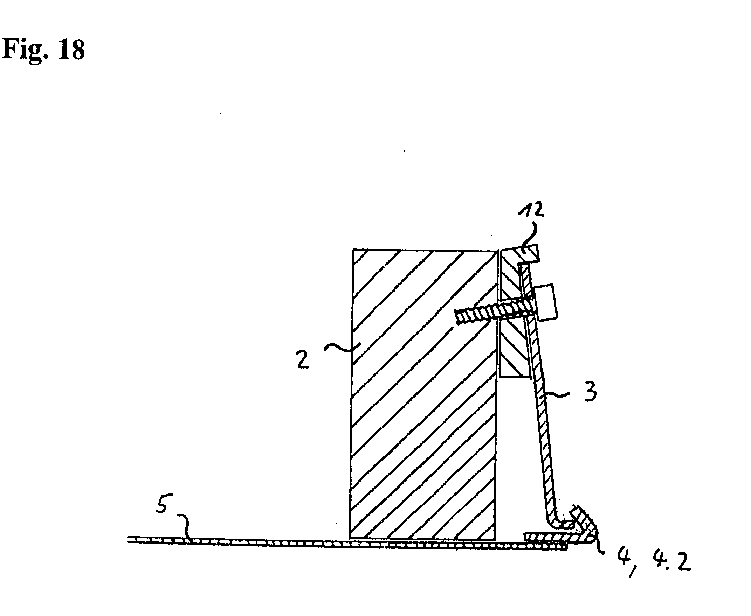

- Figur 18: ein Rahmenprofil mit weiteren elastischen Spannmitteln im Schnitt;

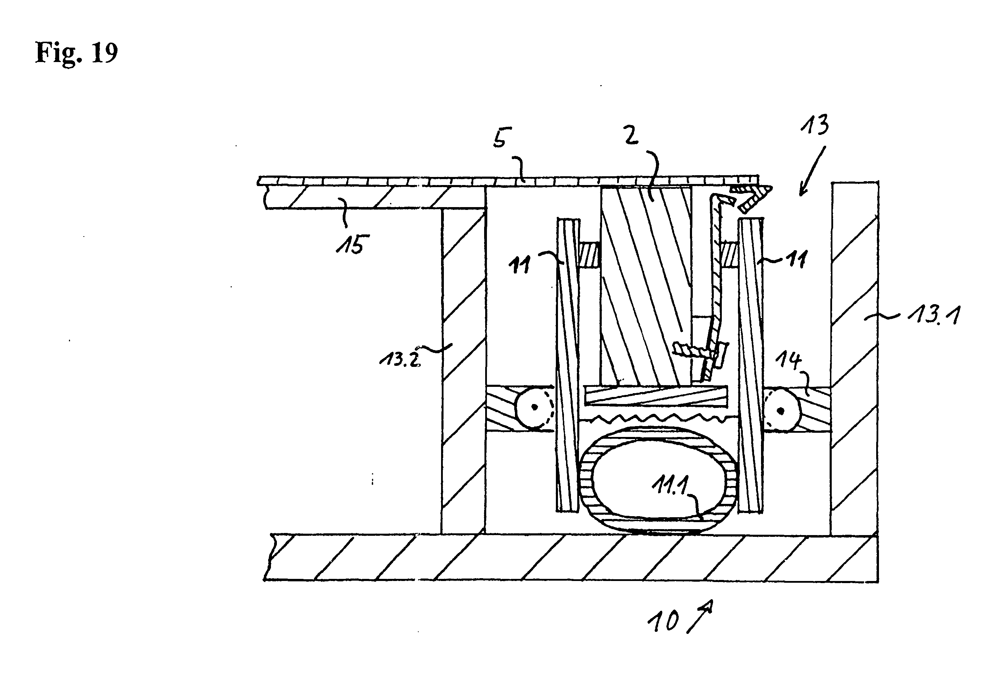

- Figur 19: einen Ausschnitt einer weiteren Vorspannvorrichtung im Schnitt;

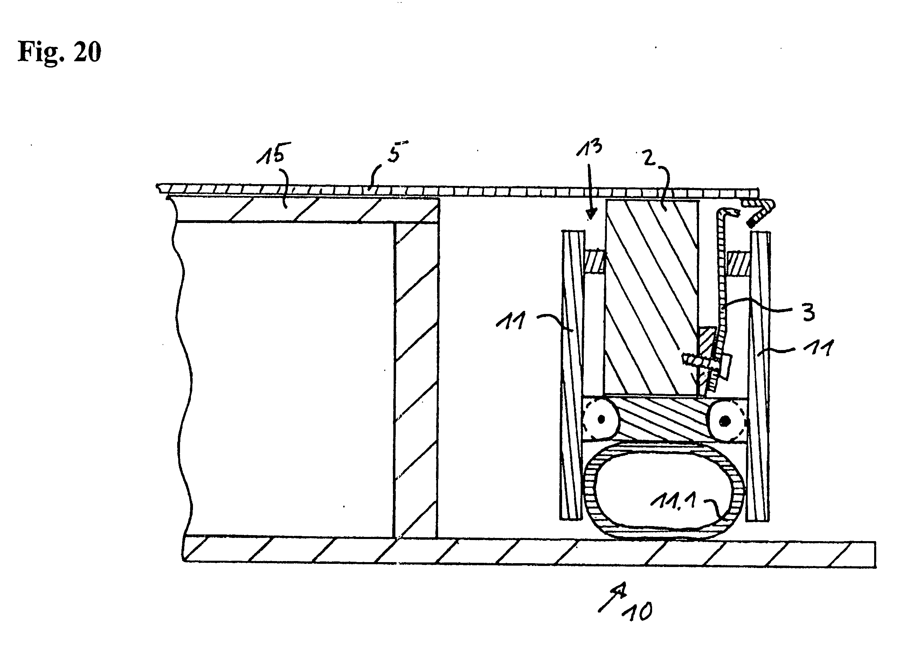

- Figur 20: einen Ausschnitt einer noch weiteren Vorspannvorrichtung im Schnitt.

Die Figur 17 zeigt in schematischer Darstellung ein weiteres vorteilhaftes Ausführungsbeispiel einer erfindungsgemäßen Druckschablone 5. Dabei kann die Druckschablone, wie in Figur 17 gezeigt, rechteckig oder vieleckig, insbesondere sechseckig oder achteckig, sein. An wenigstens einem Rand der Schablone, vorzugsweise an wenigstens zwei gegenüberliegenden Rändern, sind vorzugsweise benachbarte kurze Profilleisten 4.2 in einer vorbestimmten Mehrzahl und mit vorbestimmten Abständen angeordnet. Die kurzen Profilleisten 4.2 besitzen vorzugsweise im wesentlichen den gleichen Querschnitt wie die Profilleisten 4 der vorhergehenden Ausführungsbeispiele, die sich jeweils im wesentlichen längs einer Kante der Druckschablone erstrecken. Vorzugsweise sind die Längen und die Anzahl der benachbarten kurzen Profilleisten an einem Rand der Druckschablone an ein vorteilhaftes Spannen mittels der elastischen Spannmittel des zugehörigen erfindungsgemäßen Spannrahmens angepasst. Die kurzen Profilleisten 5 weisen im wesentlichen keine ungewollten, herstellungsbedingten Krümmungen auf und ermöglichen eine verbesserte Verteilung der Zugkräfte der elastischen Spannelemente des Spannrahmens auf die Schablonenfolie.

Eine verbesserte Verteilung der Zugkräfte ermöglichen auch die Schlitze 5.2, die an den Rändern der Druckschablone vorzugsweise zwischen benachbarten kurzen Profilleisten 4.2 angeordnet sind und die Schablonenfolie vorzugsweise in ihrer gesamten Stärke durchdringen. Die Schlitze 5.2 erstrecken sich vorzugsweise von den Kanten der Druckschablone in der jeweiligen Zugrichtung, d.h. im wesentlichen in senkrechter Richtung zu den kurzen Profilleisten 4.2. Der mittlere Bereich der Druckschablone, bzw. eines entsprechenden Rohlings für eine Druckschablone, der noch kein - bei der in der Figur 17 gezeigten Druckschablone nicht dargestelltes - Druckbild aufweist, ist vorzugsweise von den Schlitzen 5.2 freigehalten, die sich innerhalb eines vorbestimmten Randbereichs der Druckschablone erstrekken, dessen Breite an eine vorteilhafte Verteilung der Zugkräfte angepasst ist, jedoch die mechanische Stabilität und die Handhabbarkeit der Druckschablone im wesentlichen nicht beeinträchtigen.

In der Figur 17 sind die Druckschablone 5, die kurzen Profilleisten 4.2 und die Schlitze 5.2 nicht maßstabsgetreu sondern rein schematisch dargestellt. Die benachbarten kurzen Profilleisten sind vorzugsweise mit geringen Abständen angeordnet. Die gezeigte Anordnung der Profilleisten, die die Kanten der Druckschablone nach außen überragen, weist den Vorteil auf, dass die Druckschablone keine scharfen Kanten besitzt und eine sichere Handhabung ermöglicht.

Die Figur 18 zeigt ein weiteres vorteilhaftes Ausführungsbeispiel eines Rahmenprofils 2 des erfindungsgemäßen Spannrahmens mit einem darunter angeordneten Abschnitt einer gespannten Druckschablone 5. An der Außenseite 2.2 des Rahmenprofils ist ein elastisches Spannmittel 3 angeordnet, das mit einem oberen Abschnitt 3.1 mittels eines Sockelstücks 12 mit einem oberen Abschnitt 2.2.1 der Außenseite des Rahmenprofils 2 fest verbunden ist. Das Sockelstück 12 ist zwischen dem Rahmenprofil 2 und dem elastischen Spannmittel 3 angeordnet, mit dem elastischen Spannmittel und dem Rahmenprofil fest verbunden, beispielsweise mittels Schrauben, und schließt in seinem Querschnitt einen vorbestimmten, vorzugsweise spitzen Winkel ein, der in Richtung zu der Unterseite 2.1 des Rahmenprofils und der Druckschablone 5 hin geöffnet ist.

Vorzugsweise ist die Außenseite 2.2 des Rahmenprofils im wesentlichen als senkrechte Fläche ausgebildet und der Winkel, den das elastische Spannmittel 3 und das Rahmenprofil 2 einschließen, entspricht vorzugsweise im wesentlichen dem spitzwinkeligen Querschnitt des Sockelstücks 12. Das Sockelstück erstreckt sich vorzugsweise nicht bis zu dem unteren Abschnitt 2.2.2 der Außenseite des Rahmenprofils, die vorzugsweise mit dem Sockelstück eine Stufe bildet, die eine Auslenkung des unteren Abschnitts 3.2 des elastischen Spannmittels beim Spannen in Richtung zu dem Rahmenprofil hin ermöglicht. Bei besonders bevorzugten Ausführungsformen schließt das Sockelstück einen vorbestimmten geringen Winkel ein, der eine nahezu senkrechte Anordnung des elastischen Spannmittels an dem Rahmenprofil und eine vorteilhafte große Kraftkomponente der Spannkraft ermöglicht, die von dem elastischen Spannmittel auf eine Profilleiste der Druckschablone ausgeübt werden kann.

Das untere Ende des elastischen Spannmittels, dass vorzugsweise als Blattfeder oder als Blattfederstapel ausgebildet ist, kann ein nach außen weisendes Eingriffsmittel 6 tragen.

An einem Rahmenprofil kann ein Sockelstück mit einer vorbestimmten Breite für ein einzelnes oder für eine vorbestimmte Mehrzahl von benachbarten elastischen Spannmittel oder können eine vorbestimmte Mehrzahl von benachbarte Sockelstücken mit vorbestimmten Breiten für ein einzelnes oder eine vorbestimmte Mehrzahl von benachbarten elastischen Spannmitteln angeordnet sein. Vorzugsweise sind an einem Rahmenprofil eine vorbestimmte Mehrzahl von im wesentlichen unmittelbar benachbarten elastischen Spannelementen jeweils mittels Sokkelstücken mit angepasster Breite befestigt. Bei weiteren bevorzugten Ausführungsformen ist ein Rahmenprofil mittels des Strangpressverfahrens hergestellt und innen hohl. Es weist vorzugsweise im Schnitt ein Profil auf, das einem rechteckigen Profil mit dem vorstehend beschreibenen, seitlich angefügten Sockelstück entspricht.

Die Figur 19 zeigt einen Ausschnitt einer erfindungsgemäßen Vorspannvorrichtung mit einem zugehörigen Spannrahmen mit gespannten elastischen Spannmitteln für einen Wechsel der Druckschablone. Die Figur 19 zeigt einen Ausschnitt mit einem rechten Randbereich einer weiteren Ausführungsform der erfindungsgemäßen Vorspannvorrichtung 10 mit einer Öffnung 13 für ein Rahmenprofil 2 eines zugehörigen Spannrahmens auf. Als bewegliche Leisten ausgebildete Kraftübertragungsmittel 11 sind mittels Lagerungen 14 an der äußeren seitlichen Begrenzung 13.1 und der inneren seitlichen Begrenzung 13.2 der Öffnung beweglich angeordnet. Zwischen den Kraftübertragungsmitteln 11 ist eine untere Begrenzung 13.3 der Öffnung angeordnet, die vorzugsweise an ihren nicht gezeigten Enden mit der Vorspannvorrichtung verbunden ist. Unterhalb der Lagerungen 14 und vorzugsweise unterhalb der unteren Begrenzung 13.3 ist zwischen den Kraftübertragungsmitteln 11 ein Druckschlauch 11.1 angeordnet, der mit Druckluft beaufschlagbar ist, um einen Druck auf die unteren Enden der als Kraftübertragungsmittel 11 auszuüben.

In der Figur 19 ist zwischen den beweglichen Kraftübertragungsmitteln 11 auf der unteren Begrenzung 13.3 der Öffnung 13 ein Rahmenprofil 2 eines zugehörigen Spannrahmens mit einem Sockelstück 12 und einem elastischen Spannmittel 3 auf der Außenseite des Rahmenprofils angeordnet. Die Unterseite 2.1 des Rahmenprofils 2 weist dabei nach oben. Ein Abschnitt von einem Rand der zugehörigen Druckschablone 5 liegt auf der Unterseite 2.1 des Rahmenprofils und auf einer Auflagefläche 15 in einem mittleren Bereich der Vorspannvorrichtung auf. Das elastische Spannmittel 3 ist mittels der beweglichen Kraftübertragungsmittel 11 gespannt. Das untere Ende des elastischen Spannmittels ist in Richtung zu dem Rahmenprofil 2 hin verlagert, so dass sein unteres Ende, insbesondere ein daran angeordnetes Eingriffsmittel 6, nicht in die Profilleiste 4, 4.2 der Druckschablone eingreift.

Die Figur 20 zeigt einen Ausschnitt einer erfindungsgemäßen Vorspannvorrichtung mit einem zugehörigen Spannrahmen mit gespannten elastischen Spannmitteln für einen Wechsel der zugehörigen Druckschablone. Die Vorspannvorrichtung 10 weist zwei als bewegliche Leisten ausgebildete Kraftübertragungsmittel 11 mit einem dazwischen angeordneten Lagerungsprofil 14.2 auf. Das Lagerungsprofil ist an seinen nicht gezeigten Enden mit der Vorspannvorrichtung 10 fest verbunden. Die beweglichen Leisten 11 sind jeweils an einem unteren Abschnitt an gegenüberliegenden Seiten des Lagerungsprofils 14.2 beweglich gelagert.

Zwischen den beweglichen Kraftübertragungsmitteln 11 auf dem Lagerungsprofil 14.2 der Vorspannvorrichtung ist ein Rahmenprofil 2 eines zugehörigen Spannrahmens mit einem Sockelstück 12 und einem elastischen Spannmittel 3 angeordnet. Die Unterseite 2.1 des Rahmenprofils 2 weist dabei nach oben. Ein Abschnitt von einem Rand der zugehörigen Druckschablone 5 liegt auf der Unterseite 2.1 des Rahmenprofils und auf einer Auflagefläche 15 in einem mittleren Bereich der Vorspannvorrichtung auf. Das elastische Spannmittel 3 ist mittels der beweglichen Kraftübertragungsmittel 11 gespannt. Das untere Ende des elastischen Spannmittels ist in Richtung zu dem Rahmenprofil 2 hin verlagert, so dass das untere Ende des elastischen Spannmittels 3 nicht in die Profilleiste 4, 4.2 der Druckschablone eingreift.

## Patentansprüche

1. Spannrahmen (1) mit zwei gegenüberliegenden, elastische Spannmittel tragenden Rahmenprofilen mit einer lösbar verbundenen Druckschablone, wobei die elastischen Spannmittel mittels Eingriffsmitteln unter Spannung in parallele Profilleisten in gegenüberliegenden Randbereichen der Schablone eingreifen,
**dadurch gekennzeichnet, dass**
ein oberer Abschnitt (3.1, 7.2) der elastischen Spannmittel (3) mit den Rahmenprofilen (2) fest verbunden ist, die mit ihren Unterseiten (2.1) weitgehend plan auf der Druckschablone (5) aufliegen, und die Eingriffsmittel (6) in die mit der Druckschablone fest verbundenen, die Oberseite der Schablone überragenden Profilleisten (4) eingreifen und die Druckschablone mit ihrer gesamten Fläche einschließlich ihrer Randbereiche (5.1) weitgehend plan in einer Ebene gespannt halten, wobei die elastischen Spannmittel in Richtung zu den Rahmenprofilen hin vorspannbar sind.

2. Spannrahmen (1) mit zwei gegenüberliegenden, elastische Spannmittel tragenden Rahmenprofilen für eine mittels der elastischen Spannmittel lösbar verbindbare Druckschablone, wobei die elastischen Spannmittel an einen lösbaren Eingriff mittels Eingriffsmitteln unter Spannung in parallele Profilleisten in gegenüberliegenden Randbereichen der Schablone angepasst ausgebildet sind,
**gekennzeichnet durch**
die mit ihren Unterseiten (2.1) weitgehend plan auf der Druckschablone aufliegenden, elastische Spannmittel (3) tragenden Rahmenprofile (2) und die in die mit der Druckschablone (5) fest verbundenen, die Oberseite der Schablone überragenden Profilleisten (4) eingreifenden, die Druckschablone mit ihrer gesamten Fläche einschließlich ihrer Randbereiche (5.1) weitgehend plan in einer Ebene gespannt haltenden Eingriffsmittel (6) , wobei die elastischen Spannmittel mit einem oberen Abschnitt (3.2, 7.2) mit den Rahmenprofilen verbunden und in Richtung zu den Rahmenprofilen hin vorspannbar sind.

3. Spannrahmen nach Anspruch 1 oder 2, insbesondere mit einer lösbar verbundenen Druckschablone, wobei die elastischen Spannmittel mit oberen Abschnitten (3.1) an oberen Abschnitten (2.2.1) der Außenseiten der Rahmenprofile in fester Verbindung angeordnet sind.

4. Spannrahmen nach einem oder mehreren der Ansprüche 1 bis 3, insbesondere mit einer lösbar verbundenen Druckschablone, wobei die unteren Abschnitte (3.2) der elastischen Spannmitteln (3) an einen lösbaren Eingriff in die mit der Druckschablone verbundenen Profilleisten (4) angepasste Eingriffsmittel (6) tragen, insbesondere im wesentlichen hakenförmig, schenkel- oder nasenförmig ausgebildete Eingriffsmittel (6) für einen lösbaren Eingriff in einen im wesentlichen spitzwinkeligen oder U-förmigen Querschnitt aufweisende Profilleisten (4).

5. Spannrahmen nach einem oder mehreren der Ansprüche 1 bis 4, insbesondere mit einer lösbar verbundenen Druckschablone, mit zwei gegenüberliegenden, an ihren Außenseiten (2.2) als Blattfedern ausgebildete elastische Spannmittel (3) tragenden Rahmenprofilen, insbesondere mit als abgewinkelte untere Randbereiche der Blattfedern ausgebildeten Eingriffsmitteln (6).

6. Rechteckiger Spannrahmen (1) nach einem oder mehreren der Ansprüche 1 bis 5, insbesondere mit einer lösbar verbundenen Druckschablone, mit an allen vier Rahmenprofilen (2) auf den Außenseiten (2.2) angeordneten, elastischen Spannmitteln (3).

7. Rechteckiger Spannrahmen nach Anspruch 6 mit sich über einen vorbestimmten Abschnitt der Breite eines Rahmenprofils (2) erstreckenden, an die Länge der auf der Druckschablone angeordneten Profilleisten (4) angepassten, elastischen Spannmitteln.

8. Vieleckig, insbesondere achteckig ausgebildeter Spannrahmen (1) nach einem oder mehreren der Ansprüche 1 bis 7, insbesondere mit einer lösbar verbundenen Druckschablone.

9. Spannrahmen (1) nach einem oder mehreren der Ansprüche 1 bis 8, insbesondere mit einer lösbar verbundenen Druckschablone, mit wenigstens einem mit dem oberen Abschnitt (2.2.1) der Außenseite (2.2) eines Rahmenprofils (2) fest verbundenen Spannprofil (7) und einem mit dem unteren Abschnitt (2.2.2) der Außenseite des Rahmenprofils verbundenen, einen unteren beweglichen Abschnitt (7.2) des Spannprofils vorspannenden Federmittel (8) und einem an dem unteren Ende des Spannprofils für einen lösbaren Eingriff in eine Profilleiste einer Druckschablone ausgebildeten Eingriffsmittel (6).

10. Spannrahmen (1) nach einem oder mehreren der Ansprüche 1 bis 9, insbesondere mit einer lösbar verbundenen Druckschablone, mit wenigstens einem zwischen einem oberen Abschnitt eines Rahmenprofils und einem oberen Abschnitt wenigstens eines elastischen Spannmittels angeordneten, im wesentlichen keilförmigem Sockelstück (12).

11. Spannrahmen (1) nach einem oder mehreren der Ansprüche 1 bis 10, insbesondere mit einer lösbar verbundenen Druckschablone, wobei die Rahmenprofile mittels eines Strangpressverfahrens hergestellte Leichtmetallprofile mit vorbestimmten Querschnitten sind.

12. Druckschablone (5) mit an den Rändern angeordneten, mit der Schablonenfolie fest verbundenen, im wesentlichen aus zwei Schenkeln bestehenden Profilleisten, deren Schenkel in Richtung zu der Schablonenmitte hinweisen, wobei die Öffnungen ihrer im wesentlichen U-förmigen oder spitzwinkeligen Querschnitte der Schablonenmitte zugewandt sind.

13. Druckschablone nach Anspruch 12 mit jeweils an einem Rand der Druckschablone (5) an Stelle einer durchgehenden Profilleiste einer vorbestimmten Anzahl von mehreren mit vorbestimmten Abständen zueinander angeordneten Profilleisten.

14. Druckschablone nach Anspruch 12 oder 13 mit wenigstens einem Rand mit einer vorbestimmten Mehrzahl benachbart angeordneter, kurzer Profilleisten mit vorbestimmten Längen, wobei jeweils zwischen zwei benachbarten kurzen Profilleisten ein schmaler, sich in der Zugrichtung von der äußeren Kante der Schablonenfolie mit einer vorbestimmten Länge erstreckender Schlitz ausgebildet ist.

15. Druckschablone nach einem oder mehreren der Ansprüche 12 bis 14, wobei die Profilleisten mit ihren äußeren Kanten die Kanten der Schablonenfolie überragen.

16. Verfahren zum Spannen einer Druckschablone nach Anspruch 12 oder 13 mittels eines Spannrahmens nach einem oder mehreren der Ansprüche 1 bis 9 mit einem ersten Schritt, bei dem elastische Spannmittel (3) an wenigstens zwei gegenüberliegenden Rahmenprofilen (2) des Spannrahmens vorgespannt werden, und einem zweiten Schritt, bei dem der Spannrahmen auf eine Druckschablone (5) mit wenigstens zwei an gegenüberliegenden Rändern angeordneten, parallelen Profilleisten (4) aufgesetzt wird; und einem dritten Schritt, bei dem die Vorspannung der Spannmittel verringert wird, bis die Spannmittel unter Vorspannung in die Profilleisten eingreifen und die Druckschablone im wesentlichen plan gespannt halten.

17. Verfahren zum Spannen einer Druckschablone nach einem oder mehreren der Ansprüche 12 bis 15 mittels eines Spannrahmens nach einem oder mehreren der Ansprüche 1 bis 11 mit einem ersten Schritt, bei dem elastische Spannmittel (3) an wenigstens zwei gegenüberliegenden Rahmenprofilen (2) des Spannrahmens vorgespannt werden, und einem zweiten Schritt, bei dem der Spannrahmen auf eine Druckschablone (5) mit wenigstens zwei an gegenüberliegenden Rändern angeordneten, parallelen Profilleisten (4) aufgesetzt wird; und einem dritten Schritt, bei dem die Vorspannung der Spannmittel verringert wird, bis die Spannmittel unter Vorspannung in die Profilleisten eingreifen und die Druckschablone im wesentlichen plan gespannt halten.

18. Verfahren zum Spannen einer Druckschablone (5) im wesentlichen in einer Ebene, mit einem ersten Schritt, wobei ein spannbarer unterer Abschnitt (3.2, 3.7) wenigstens eines elastischen Spannmittels (3) an der Außenseite (2.2) wenigstens eines Rahmenprofils (2) eines Spannrahmens (1) zu der unteren Längskante des Rahmenprofils hin ausgelenkt und gespannt wird; einem zweiten Schritt, wobei eine Druckschablone mit wenigstens einer an einem Rand (5.1) angeordneten Profilleiste (4, 4.2) an der Unterseite (2.1) des Spannrahmens angeordnet wird, so dass die Profilleiste neben der Längskante des Rahmenprofils mit dem unteren Ende des gespannten elastischen Spannmittels zu liegen kommt, und einem dritten Schritt, wobei die Spannung des elastischen Spannmittels verringert wird, bis das elastische Spannmittel mit seinem unteren Ende in die Profilleiste der Druckschablone eingreift und die Druckschablone einschließlich ihres Randbereichs (5.1) im wesentlichen in einer Ebene gespannt hält.

19. Verwendung eines Spannrahmens nach einem oder mehreren der Ansprüche 1 bis 9 mit einer Druckschablone nach Anspruch 12 oder 13 für den Auftrag von Lotpaste auf elektronische Leiterplatten.

20. Verwendung eines Spannrahmens nach einem oder mehreren der Ansprüche 1 bis 11 mit einer Druckschablone nach einem oder mehreren der Ansprüche 12 bis 15 für den Auftrag von Lotpaste auf elektronische Leiterplatten.

21. Verwendung eines Spannrahmens nach einem oder mehreren der Ansprüche 1-9 für eine Druckschablone nach Anspruch 12 oder 13.

22. Verwendung eines Spannrahmens nach einem oder mehreren der Ansprüche 1-11 für eine Druckschablone nach einem oder mehreren der Ansprüche 12 bis 15.

23. Verwendung der Druckschablone (5) nach einem oder mehreren der Ansprüche 12 bis 15 oder einer Druckschablone mit wenigstens einer im wesentlichen die Schablonenoberfläche überragenden, umgebogenen Kante zum Spannen mittels eines Spannrahmens nach einem oder mehreren der Ansprüche 1 bis 11, insbesondere für den Auftrag von Lotpasten auf elektronische Leiterplatten.

24. Verwendung nach Anspruch 23, wobei die Druckschablone (5) aus einer Metallfolie, insbesondere aus einer Edelstahlfolie oder einer mittels eines galvanischen Additivverfahrens hergestellten Nickelschablone mit Durchbrechungen oder einer Kunststofffolie mit hoher Zugfestigkeit, insbesondere einer Polyimidfolie besteht.

## Claims

1. Tensioning frame (1) having two frame profiles which lie opposite one another and bear elastic tensioning means, having a releasably connected printing stencil, the elastic tensioning means engaging by means of engagement means, under tension, in parallel profiled strips in opposite edge regions of the stencil, **characterized in that** an upper section (3.1, 7.2) of the elastic tensioning means (3) is connected fixedly to the frame profiles (2) whose undersides (2.1) rest largely flatly on the printing stencil (5), and the engagement means (6) engage into the profiled strips (4), which are connected fixedly to the printing stencil and protrude beyond the upper side of the stencil, and hold the whole surface of the printing stencil including its edge regions (5.1) tensioned largely flatly in one plane, it being possible to pretension the elastic tensioning means in the direction towards the frame profiles.

2. Tensioning frame (1) having two frame profiles which lie opposite one another and bear elastic tensioning means, for a printing stencil which can be connected releasably by means of the elastic tensioning means, the elastic tensioning means being configured in a manner adapted to a releasable engagement, under tension, by means of engagement means in parallel profiled strips in opposite edge regions of the stencil, **characterized by** the frame profiles (2), which bear elastic tensioning means (3) and whose undersides (2.1) rest largely flatly on the printing stencil, and the engagement means (6) which engage in the profiled strips (4), the latter being connected fixedly to the printing stencil (5) and protruding beyond the upper side of the stencil, and which hold the whole surface of the printing stencil including its edge regions (5.1) tensioned largely flatly in one plane, the elastic tensioning means being connected via an upper section (3.2, 7.2) to the frame profiles and it being possible to pretension the said elastic tensioning means in the direction towards the frame profiles.

3. Tensioning frame according to Claim 1 or 2, in particular having a releasably connected printing stencil, upper sections (3.1) of the elastic tensioning means being arranged on upper sections (2.2.1) of the outer sides of the frame profiles in a fixed connection.

4. Tensioning frame according to one or more of Claims 1 to 3, in particular having a releasably connected printing stencil, the lower sections (3.2) of the elastic tensioning means (3) bearing engagement means (6) adapted to a releasable engagement in the profiled strips (4) connected to the printing stencil, in particular engagement means (6) configured to be substantially in the shape of a hook, leg or lug for a releasable engagement into profiled strips (4) which have a substantially acute or U-shaped cross section.

5. Tensioning frame according to one or more of Claims 1 to 4, in particular having a releasably connected printing stencil, having two frame profiles which lie opposite one another and bear, on their outer sides (2.2), elastic tensioning means (3) configured as leaf springs, in particular having engagement means (6) configured as angled-over lower edge regions of the leaf springs.

6. Rectangular tensioning frame (1) according to one or more of Claims 1 to 5, in particular having a releasably connected printing stencil, having elastic tensioning means (3) which are arranged on the outer sides (2.2) of all four frame profiles (2).

7. Rectangular tensioning frame according to Claim 6, having elastic tensioning means which extend over a predetermined section of the width of a frame profile (2) and are adapted to the length of the profiled strips (4) arranged on the printing stencil.

8. Polygonal, in particular octagonal tensioning frame (1) according to one or more of Claims 1 to 7, in particular having a releasably connected printing stencil.

9. Tensioning frame (1) according to one or more of Claims 1 to 8, in particular having a releasably connected printing stencil, having at least one tensioning profile (7) which is connected fixedly to the upper section (2.2.1) of the outer side (2.2) of a frame profile (2), having a spring means (8) which is connected to the lower section (2.2.2) of the outer side of the frame profile and pretensions a lower movable section (7.2) of the tensioning profile, and having an engagement means (6) which is configured at the lower end of the tensioning profile for a releasable engagement in a profiled strip of a printing stencil.

10. Tensioning frame (1) according to one or more of Claims 1 to 9, in particular having a releasably connected printing stencil, having at least one substantially wedge-shaped pedestal element (12) which is arranged between an upper section of a frame profile and an upper section of at least one elastic tensioning means.

11. Tensioning frame (1) according to one or more of Claims 1 to 10, in particular having a releasably connected printing stencil, the frame profiles being lightweight metal profiles produced by means of an extrusion press method and having predetermined cross sections.

12. Printing stencil (5) having profiled strips which are arranged at the edges, are connected fixedly to the stencil sheet, substantially comprise two limbs and whose limbs point in the direction towards the stencil centre, the openings of their substantially U-shaped or acute cross sections facing the stencil centre.

13. Printing stencil according to Claim 12, having, in each case at an edge of the printing stencil (5) and instead of a continuous profiled strip, a predetermined number of a plurality of profiled strips arranged at predetermined spacings from one another.

14. Printing stencil according to Claim 12 or 13, having at least one edge with a predetermined plurality of short profiled strips having predetermined lengths and arranged adjacent to one another, one narrow slot which extends from the outer edge of the stencil sheet in the tensile direction and has a predetermined length being configured in each case between two adjacent short profiled strips.

15. Printing stencil according to one or more of Claims 12 to 14, the outer edges of the profiled strips protruding beyond the edges of the stencil sheet.

16. Method for tensioning a printing stencil according to Claim 12 or 13 by means of a tensioning frame according to one or more of Claims 1 to 9, having a first step in which elastic tensioning means (3) are pretensioned on at least two frame profiles (2) of the tensioning frame lying opposite one another, and having a second step in which the tensioning frame is placed on a printing stencil (5) having at least two parallel profiled strips (4) arranged at opposite edges; and having a third step in which the pretensioning of the tensioning means is reduced until the tensioning means engage in the profiled strips under pretension and hold the printing stencil in a substantially flatly tensioned manner.

17. Method for tensioning a printing stencil according to one or more of Claims 12 to 15 by means of a tensioning frame according to one or more of Claims 1 to 11, having a first step in which elastic tensioning means (3) are pretensioned on at least two frame profiles (2) of the tensioning frame lying opposite one another, having a second step in which the tensioning frame is placed on a printing stencil (5) having at least two parallel profiled strips (4) arranged at opposite edges; and having a third step in which the pretensioning of the tensioning means is reduced until the tensioning means engage into the profiled strips under pretension and hold the printing stencil in a substantially flatly tensioned manner.

18. Method for tensioning a printing stencil (5) substantially in one plane, having a first step, a lower section (3.2, 3.7) which can be tensioned of at least one elastic tensioning means (3) on the outer side (2.2) of at least one frame profile (2) of a tensioning frame (1) being deflected out towards the lower longitudinal edge of the frame profile and tensioned; having a second step, a printing stencil having at least one profiled strip (4, 4.2) arranged at one edge (5.1) being arranged on the underside (2.1) of the tensioning frame, with the result that the profiled strip next to the longitudinal edge of the frame profile comes to lie with the lower end of the tensioned elastic tensioning means, and having a third step, the tensioning of the elastic tensioning means being reduced until the lower end of the elastic tensioning means engages in the profiled strip of the printing stencil and holds the printing stencil, including its edge region (5.1), in a tensioned manner substantially in one plane.

19. Use of a tensioning frame according to one or more of Claims 1 to 9 having a printing stencil according to Claim 12 or 13 for the application of solder paste onto electronic circuit boards.

20. Use of a tensioning frame according to one or more of Claims 1 to 11 having a printing stencil according to one or more of Claims 12 to 15 for the application of solder paste on electronic circuit boards.

21. Use of a tensioning frame according to one or more of Claims 1 to 9 for a printing stencil according to Claim 12 or 13.

22. Use of a tensioning frame according to one or more of Claims 1 to 11 for a printing stencil according to one or more of Claims 12 to 15.

23. Use of the printing stencil (5) according to one or more of Claims 12 to 15 or a printing stencil having at least one bent-over edge which protrudes substantially beyond the stencil surface for tensioning by means of a tensioning frame according to one or more of Claims 1 to 11, in particular for the application of solder pastes to electronic circuit boards.

24. Use according to Claim 23, the printing stencil (5) consisting of a metal sheet, in particular of a special steel sheet or a nickel stencil produced by means of a galvanic additive method and having apertures, or of a plastic sheet having a high tensile strength, in particular a polyimide sheet.

## Revendications

1. Cadre tendeur (1), comprenant deux profilés de cadre opposés, portant des moyens tendeurs élastiques, avec un pochoir d'impression, relié de façon désolidarisable, les moyens tendeurs élastiques s'engageant, à l'aide de moyens d'engagement, sous tension mécanique, dans des barres profilées parallèles, dans des zones de bordure opposées du pochoir,
**caractérisé en ce qu'**un tronçon supérieur (3.1, 7.2) des moyens tendeurs élastiques (3) est relié rigidement aux profilés de cadre (2) qui reposent, par leurs faces inférieures (2.1), sensiblement de façon plane, sur le pochoir d'impression (5), et les moyens d'engagement (6) s'engagent dans les barres profilées (4), reliées rigidement au pochoir d'impression, dépassant de la face supérieure du pochoir, et maintenant le pochoir d'impression, tendu de façon sensiblement plane dans un plan, par la totalité de sa surface, y compris de ses zones de bordures (5.1), les moyens tendeurs élastiques étant susceptibles d'être précontraints dans la direction des profilés de cadre.

2. Cadre tendeur (1), comprenant deux profilés de cadre opposés, portant des moyens tendeurs élastiques, pour un pochoir d'impression susceptible d'être relié de façon désolidarisable à l'aide des moyens tendeurs élastiques, les moyens tendeurs élastiques étant réalisés de façon adaptée à une emprise désolidarisable, faite à l'aide de moyens d'engagement, sous contrainte, dans des barres profilées, dans des zones de bordure opposées du pochoir,
**caractérisé par**
des profilés de cadre (2), portant les moyens tendeurs (3) élastiques, reposant par leurs faces inférieures (2.1), de façon sensiblement plane, sur le pochoir d'impression, et des moyens d'engagement (6), maintenant, de façon tendue de façon sensiblement plane dans un plan, le pochoir d'impression (5) avec la totalité de sa surface, y compris ses zones de bordure (5.1), les moyens d'engagement s'engageant dans les barres profilées (4) dépassant de la face supérieure du pochoir, reliés rigidement au pochoir d'impression (5), les moyens tendeurs élastiques étant reliés, par un tronçon supérieur (3.2, 7.2), aux profilés de cadre et étant susceptibles d'être précontraints mécaniquement dans la direction des profilés de cadre.

3. Cadre tendeur selon la revendication 1 ou 2, en particulier avec un pochoir d'impression relié de façon désolidarisable, les moyens tendeurs élastiques étant disposés en liaison rigide avec des tronçons supérieurs (3.1) sur des tronçons supérieurs (2.2.1) des faces extérieures des profilés de cadre.

4. Cadre tendeur selon l'une ou plusieurs des revendications 1 à 3, en particulier avec un pochoir d'impression relié de façon désolidarisable, les tronçons inférieurs (3.2) des moyens tendeurs (3) élastiques portant des moyens d'engagement (6), adaptés à un engagement désolidarisable dans les barres profilées (4) reliées au pochoir d'impression, en particulier des moyens d'engagement, sensiblement en forme de crochet, de branche, ou d'ergot, pour un engagement désolidarisable dans une barre profilées (4), présentant une section transversale sensiblement à angle aigu ou en forme de U.

5. Cadre tendeur selon l'une ou plusieurs des revendications 1 à 4, en particulier avec un pochoir d'impression relié de façon désolidarisable, avec deux moyens tendeurs (3) élastiques opposés, réalisés sous forme de ressorts à lame sur ses côtés extérieurs (2.2), en particulier avec des moyens d'engagement (6), réalisés sous la forme de zones de bordure inférieures coudées, des ressorts à lame.

6. Cadre tendeur (1) rectangulaire selon l'une ou plusieurs des revendications 1 à 5, en particulier avec un pochoir d'impression relié de façon désolidarisable, avec des moyens tendeurs (3) élastiques, disposés sur les faces extérieures (2.2), sur la totalité des quatre profilés de cadre (2).

7. Cadre tendeur rectangulaire selon la revendication 6, comprenant des moyens tendeurs élastiques, s'étendant sur un tronçon prédéterminé de la largeur d'un profilé de cadre (2), adaptés à la longueur des barres profilées (4), disposées sur le pochoir d'impression.

8. Cadre tendeur (1) polygonal, en particulier octogonal, selon l'une ou plusieurs des revendications 1 à 7, en particulier avec un pochoir d'impression relié de façon désolidarisable.

9. Cadre tendeur (1) selon l'une ou plusieurs des revendications 1 à 8, en particulier avec un pochoir d'impression relié de façon désolidarisable, avec au moins un profilé tendeur (7), relié rigidement au tronçon supérieur (2.2.1) de la face extérieure (2.2) d'un profilé de cadre (2) et des moyens élastiques (8) précontraignant un tronçon mobile inférieur (7.2) du profilé de cadre et relié au tronçon inférieur (2.2.2) de la face extérieure du profilé de cadre, et avec un moyen d'engagement (6), réalisé sur l'extrémité inférieure du profilé tendeur, afin de permettre un engagement désolidarisable dans une barre profilée d'un pochoir d'impression.

10. Cadre tendeur (1) selon l'une ou plusieurs des revendications 1 à 9, en particulier avec un pochoir d'impression relié de façon désolidarisable, avec au moins un élément de socle (12) sensiblement cunéiforme, disposé entre un tronçon supérieur d'un profilé de cadre et un tronçon supérieur d'au moins un moyen tendeur élastique.

11. Cadre tendeur (1) selon l'une ou plusieurs des revendications 1 à 10, en particulier avec un pochoir d'impression relié de façon désolidarisable, les profilés de cadre étant des profilés en métal léger, ayant des sections transversales prédéterminées, produits à l'aide d'un procédé d'extrusion.

12. Pochoir d'impression (5), avec des barres profilées reliées rigidement à la feuille de pochoir et formées essentiellement de deux branches, dont les branches sont tournées dans la direction du centre de pochoir, les ouvertures de leurs sections, sensiblement en forme de U ou coudées en pointe, étant tournées vers le centre du pochoir.

13. Pochoir d'impression selon la revendication 12, avec respectivement des barres profilées disposées sur un bord du pochoir d'impression (5), à l'emplacement d'une barre profilée continue, formée d'un nombre prédéterminé d'une pluralité de barres profilées disposés les uns par rapport aux autres selon des espacements prédéterminés.

14. Pochoir d'impression selon la revendication 12 ou 13, avec au moins un bord comprenant une pluralité prédéterminée de barres profilées courtes, disposées au voisinage les unes des autres et ayant des longueurs prédéterminées, sachant que, chaque fois entre deux barres profilées courtes voisines, est réalisée une fente étroite s'étendant, avec une longueur prédéterminée, dans la direction de la traction, depuis l'arête extérieure de la feuille de pochoir.

15. Pochoir d'impression selon l'une ou plusieurs des revendications 12 à 14, les barres profilées dépassant des arêtes de la feuille de pochoir par leurs arêtes extérieures.

16. Procédé de mise sous tension mécanique d'un pochoir d'impression selon la revendication 12 ou 13, à l'aide d'un cadre tendeur selon l'une ou plusieurs des revendications 1 à 9, avec une première étape, lors de laquelle des moyens élastiques (3) sont précontraints sur au moins deux profilés de cadre (2) opposés du cadre tendeur, et avec une deuxième étape, lors de laquelle le cadre tendeur est posé sur un pochoir d'impression (5), comprenant au moins deux barres profilées (4) parallèles, disposées sur des bords opposées; et une troisième étape, lors de laquelle la précontrainte des moyens tendeurs est diminuée, jusqu'à ce que les moyens tendeurs s'engagent sous précontrainte dans l'élément de profilé et maintenant le pochoir d'impression serré de façon sensiblement plane.

17. Procédé de mise sous tension mécanique d'un pochoir d'impression selon l'une ou plusieurs des revendication 12 à 13, à l'aide d'un cadre tendeur selon l'une ou plusieurs des revendications 1 à 11, avec une première étape, lors de laquelle des moyens élastiques (3) sont précontraints sur au moins deux profilés de cadre (2) opposés du cadre tendeur, et avec une deuxième étape, lors de laquelle le cadre tendeur est placé sur un pochoir d'impression (5), comprenant au moins deux barres profilées (4) parallèles, disposées sur des bords opposés; et avec une troisième étape, lors de laquelle la précontrainte des moyens tendeurs est diminuée, jusqu'à ce que les moyens tendeurs s'engagent sous précontrainte dans les barres profilées et maintiennent de façon sensiblement plane le pochoir d'impression.

18. Procédé de mise sous tension mécanique d'un pochoir d'impression (5), sensiblement dans un plan, avec une première étape, sachant qu'un tronçon inférieur (3.2, 3.7), susceptible d'être tendu, d'au moins un moyen tendeur (3) élastique, est dévié et tendu sur la face extérieure (2.2) d'au moins un profilé de cadre (2) d'un cadre tendeur (1), vers l'axe longitudinal inférieur du profilé de cadre; avec une deuxième étape, selon lequel un point pochoir d'impression, comprenant au moins une barre profilée (4, 4.2), disposée sur un bord (5.1), est disposé en face inférieure (2.1) du cadre tendeur, de sorte que la barre profilée vienne se placer à côté de l'axe longitudinal du profilé de cadre par l'extrémité inférieure des moyens tendeurs élastiques tendus, et avec une troisième étape, selon lequel la tension mécanique du moyen tendeur élastique est diminuée, jusqu'à ce que le moyen tendeur élastique s'engage, par son extrémité inférieure, dans la barre profilée du pochoir d'impression et maintienne à l'état tendu, sensiblement dans un plan, le pochoir d'impression, y compris sa zone de bordure (5.1).

19. Utilisation d'un cadre tendeur selon l'une ou plusieurs des revendications 1 à 9, avec un pochoir d'impression selon la revendication 12 ou 13, pour l'application de pâte à braser sur des plaquettes à circuits imprimés électroniques.

20. Utilisation d'un cadre tendeur selon l'une ou plusieurs des revendications 1 à 11, avec un pochoir d'impression selon l'une ou plusieurs des revendications 12 à 13, pour l'application de pâte à braser sur des plaquettes à circuits imprimés électroniques.

21. Utilisation d'un cadre tendeur selon l'une ou plusieurs des revendications 1 à 9, pour un pochoir d'impression selon la revendication 12 ou 13.

22. Utilisation d'un cadre tendeur selon l'une ou plusieurs des revendications 1 à 11, pour un pochoir d'impression selon l'une ou plusieurs des revendications 12 à 15.

23. Utilisation du pochoir d'impression (5) selon l'une ou plusieurs des revendications 12 à 15, ou d'un pochoir d'impression comprenant au moins une arête repliée, dépassant sensiblement de la surface de pochoir, pour tendre au moins un cadre tendeur, selon l'une ou plusieurs des revendications 1 à 11, en particulier pour l'application de pâtes à braser sur des plaquettes à circuits imprimés électroniques.

24. Utilisation selon la revendication 23, le pochoir d'impression (5) étant formé d'une feuille métallique, en particulier d'une feuille en acier spécial, ou d'un pochoir en nickel, fabriqué par un procédé additif galvanique, avec des passages, ou bien d'une feuille en matière synthétique, présentant une haute résistance à la traction, en particulier d'une feuille de polyimide.
